# EUROPÄISCHE PATENTSCHRIFT

(11) **EP 0 798 895 B1**
(45) Veröffentlichungstag und Bekanntmachung des Hinweises auf die Patenterteilung: **25.09.2002**
(21) Anmeldenummer: 97104111.6
(22) Anmeldetag: 12.03.1997
(51) Int. Cl.: H04L 12/40, H04L 29/14, B60R 16/02, G06F 11/30, H02J 13/00, G05B 9/03

(54) **Integrierter Schaltkreis zur Kopplung eines mikrokontrollierten Steuergerätes an einen Zweidraht-Bus**
Integrated circuit for coupling a microcontrolled controlling device to a two-wire bus
Circuit de commutation intégré pour le couplage d'un contrôleur micro-contrôlé au bus à deux fils

(30) Priorität: 26.03.1996 DE 19611944
(43) Veröffentlichungstag der Anmeldung: 01.10.1997
(73) Patentinhaber: DaimlerChrysler AG, 70567 Stuttgart (DE)
(72) Erfinder: Hanf, Peter, 73035 Göppingen (DE); Minuth, Jürgen, 73054 Eislingen (DE); Setzer, Jürgen, 75428 Illingen (DE)

(56) Entgegenhaltungen:
- WO-A-93/22857
- DE-A- 3 807 566
- DE-A- 4 112 665
- DE-A- 4 126 449
- DE-A- 4 136 338
- DE-A- 4 344 238
- DE-C- 4 211 579

## Beschreibung

Die Erfindung bezieht sich auf einen integrierten Halbleiterschaltkreis für ein elektronisches Steuergerät mit Microcontroller, wobei das Steuergerät mit Mitteln zur Kommunikation mit anderen kommunikationsfähigen Steuergeräten mit Microcontrollern ausgestattet ist, um mit letzteren ein Netzwerk zu bilden, in welchem die Bus-Kommunikation protokollbasiert seriell geschicht und wofür der Bus als Zweidrahtleitung ausgebildet und jedes Steuergerät mit einer Bus-Protokoll-Modul mit Empfangseingang (Rx) und Sendeausgang (Tx) ausgestattet ist. Der Halbleiterschaltkreis weist Empfangsmittel mit zwei Eingängen zum Anschluß an die beiden Busadern und einen Ausgang zum Anschluß an den Empfangseingang des Busprotokoll-Moduls und Sendemittel mit einem Eingang zum Anschluß an den Sendeausgang des Busprotokoll-Moduls und zwei Ausgängen zum Anschluß an die beiden Busadern auf sowie Busfehler-Erkennungsmittel, die ein Auftreten eines die normale Kommunikationsweise über beide Busadern beeinträchtigenden Busfehlers erkennen, und Busfehler-Auswertungsmittel zur Aufbereitung wenigstens eines an den Mikrocontroller abgebbaren Fehler- bzw. Unterbrechungssignals.

Die wachsende Zahl CAN- busvernetzter elektronischer Geräte in Industrieanlagen und Verkehrsmitteln, beispielsweise in Kraftfahrzeugen, verlangt nach Kopplungsmitteln zum Verbund der Microcontroller untereinander über ein zweidrähtiges Busnetz. Für diesen Zweck wurden mehr oder weniger diskrete Lösungen bekannt, die sich bislang jedoch als nicht universell einsetzbar erwiesen. Insbesondere machen und halten sie das Busnetz nicht oder nicht schnell verfügbar, wenn ein schwerer Fehler am Busmedium vorliegt. Andererseits können Busfehler zu einem erhöhten Stromverbrauch des Gesamtnetzes über den Bus führen, wodurch beispielsweise im Falle des Netzbetriebs aus einer Batterie die Verfügbarkeit indirekt beeinträchtigt wird. Zum anderen Teil fehlen solchen Kopplungsmitteln netzverfügbarkeitserhöhende Managementfunktionen. Ein sehr anschauliches Beispiel hierfür liefert z.B. der Stromverbrauch in Busnetzen bzw. in Busteilnehmern während Zeiten geringer oder gar keiner Aktivität auf dem Bus, d.h. der Betriebsstromverbrauch, im Gegensatz zum vorgenannten Fehlerstromverbrauch. Daraus ergeben sich zwangsläufig Probleme hinsichtlich einer ausreichend sicheren bzw. ausreichend langen Verfügbarkeit des gesamten Busnetzes dann, wenn für den Betrieb nur eine vorbestimmte elektrische Energiemenge zur Verfügung steht, etwa aus der Starterbatterie eines Verkehrsmittels oder der Stützbatterie einer Meßstation für Noterhalt von Daten etc. Der beschränkte Energievorrat beschränkt hier sogar die Verfügbarkeit der vom Busnetz gesteuerten Applikationen und ihrer Failsafe-Routinen für den Fall eines Bus-Zusammenbruchs, m.a.W. nicht nur die Verfügbarkeit des Busses mit all seinen Kommunikationseinrichtungen als Medium.

Um den Stromverbrauch zu beschränken, ist aus der WO 90/09713 bekannt, einzelne busteilnehmende Geräte, die innerhalb einer bestimmten Betriebsphase nicht benötigt werden, ganz abzuschalten. Dazu ist dort eine Betriebsart SLEEP vorgesehen, in der bestimmte elektrische Bausteine stromlos geschaltet sind und es ist ein Wake-up-Vorgang offenbart, um diese Bausteine wieder in den Normal-Betriebszustand zu überführen.

Bei von der Anmelderin vermarkteten Kraftfahrzeugen ist bekannt, elektronische Steuergeräte, deren Stromverbrauch bei Stillstand des Fahrzeugs stört, von der Klemme 15 des Zünd-/Startschalters aus mit Strom zu versorgen. Bei abgezogenem Zünd/Start-Schlüssel sind sie so von der Bordstromversorgung ausgenommen. Geräte, deren Betriebsfähigkeit auch bei Nichtbetrieb des Fahrzeugmotors unverzichtbar ist, werden von der dauerstromversorgten Klemme 30 mit Strom versorgt.
Geht man jedoch davon aus, daß allein der Spannungsregler eines jeden solchen dauerstromversorgten Gerätes ca. 500 µA, der Ruhestrombedarf des Transceivers (Empfangsdiskriminator und Endstufe) zwischen Bus und Elektronik ca. 150 µA und der Ruhestrombedarf der jeweiligen Geräteperipherie (z.B. Spannungsteiler, Sensorstromquellen etc.) jeweils ca. 500 µA beträgt, resultiert für jedes Gerät ein Gesamtruhestrombedarf von mehr als 1 mA.

Sind beim Beispiel eines Kraftfahrzeugs mit busvernetzten Steuergeräten z.B. 30 solcher Geräte vorhanden, würde dies einen Gesamtruhestrombedarf von mindestens 30 mA bedeuten. Bei einem Kraftfahrzeug kann dies zur Folge haben, daß das außer Betrieb genommene Kraftfahrzeug infolge beständiger Entladung seiner Batterie nach ca. 3-4 Wochen nicht mehr startbar ist. Dies hat wiederum zur Folge, daß in entsprechenden Kraftfahrzeugen, die z.B. in einen anderen Kontinent verschifft werden sollen, zwecks Sicherstellung ihrer Startbarkeit am Empfangsort vor der Verschiffung eine Abtrennung der Batterie vom Bordnetz erforderlich ist.

Aus der DE 38 26 774 A1 ist eine Netzwerkschnittstelle mit einem Sende- und Empfangsmittel bekannt, wobei im Fehlerfall eine Busleitung auf den Mittenabgriff eines zwischen Masse und Ubatt angeordneten Spannungsteiler geschaltet wird, wodurch die Busleitung auf ein vorgegebenes Potential gelegt wird. Separat davon ist die Busleitung über Widerstände und einen Impedanzwandler abgeschlossen.

Schließlich ist noch in der Zeitschrift Elektronik 17/1991, Seiten 96-101, ein Mikrocontroller mit CAN-Controller beschrieben, wobei die Busankopplung des Empfangs- und des Sendemittels jeweils über Widerstände erfolgt und im Fehlerfall eine Busleitung ebenfalls auf ein vorgegebenes Potential von 2,5 V schaltbar ist. Abschlußwiderstände sind separat davon vorgesehen.

Es ist daher Aufgabe der Erfindung, einen Halbleiterschaltkreis mit alternativem Schaltungskonzept zur Kopplung eines mikrokontrollierten Steuergerätes an einen Zweidraht-Bus vorzuschlagen, wobei die Leistungsaufnahme des Datenbusses reduziert ist.

Ausgehend von einem gattungsgemäßen Schaltkreis wird diese Aufgabe im Rahmen der Erfindung mit zwei Realisierungsstrategien, die beide für sich allein zur Anwendung gelangen können, gleichwohl aber auch im Verbund verschieden gestuft sich mannigfaltig ergänzend zur Anwendung gelangen können, gemäß den Merkmalen der nebengeordneten Ansprüche 1 und 2 gelöst.

Der Schaltkreis mit den Merkmalen des Anspruch 1 erhöht die Verfügbarkeit des Busnetzes dadurch, daß er zum einen eine busfehlertolerante Transceive-Funktion realisiert, welche eine Kommunikation auch noch bei Vorliegen eines Busfehlers erlaubt, und zum anderen Busfehler-Erkennungs- und Behandlungsmittel aufweist, die den Bus im Falle eines Fehlers von seinen normalen Teilnehmerabschlüssen freizuschalten vermögen. Durch diese Maßnahme wird verhindert, daß busweit aus den Teilnehmern parasitäre Ströme über den Bus abfließen, die im Falle eines batteriegestützten Bussystems die Verfügbarkeit des Bus-Netzes durch Erschöpfen der Batteriekapazität einschränkten.
Der Schaltkreis gemäß Anspruch 1 leistet insoweit eine Erhöhung der Netz-Verfügbarkeit integral auf zwei Weisen, nämlich sowohl auf der Kommunikationsebene als auch auf der Energieebene für den Betrieb des Netzes.

Der Schaltkreis gemäß Anspruch 2 erhöht die Verfügbarkeit des Busnetzes dadurch, daß er eine Transceive-Funktion mit zwei voneinander verschiedenen, vom Microcontroller einstellbaren Betriebsarten "Senden und Empfang / NORMAL" und "Schlafen /SLEEP" realisiert. Der Schaltkreis umfaßt sowohl vom Bus aus als auch über einen besonderen Eingang aktivierbare Weckmittel, wenn er sich in der Betriebsart "SLEEP" befindet, sowie Weck-Auswertungsmittel, mittels derer entweder in der Betriebsart "SLEEP" ein in einem Lowpower- oder Shutdown-Mode, also in einem Leistungsverringerungs- oder Abschalt-Modus, gehaltener Microcontroller definiert gestartet bzw. initialisiert sowie von ihm angesteuerte Kreise zwecks Anschaltung an eine Stromversorgung angesteuert werden können, oder aber die Stromversorgung des Microcontrollers wie auch die anderer Stromverbraucher gänzlich abgeschaltet und bei Bedarf wieder kontrolliert aufgebaut werden kann.

Weitere Vorteile werden bei Fortbildung gemäß den abhängigen Ansprüchen 3 bis 19 erzielt. Im Detail wird diesbezüglich auf die Beschreibung der Ausführungsbeispiele verwiesen.

Der erfindungsgemäße integrierte Halbleiterschaltkreis verhilft einem damit ausgestatteten busvernetzten elektronischen Steuergerät zur Fähigkeit, auch unter erschwerten Kommunikationsbedingungen und/oder aus einem begrenzten Energievorrat längstmöglich kommunikationsfähig zu bleiben oder in Betriebszuständen mit reduzierter Aktivität zu verharren, aus denen heraus das Gerät auf kontrollierte Weise normale Aktivität wieder schnell entwickeln kann. Er macht die Verfügbarkeit sowohl der Busprotokoll-Funktion als auch des Microcontrollers zum Zwecke der Aufrechterhaltung sowohl der normalen Weckfähigkeit des Steuergerätes als auch der Weckfähigkeit im Busfehlerfall überflüssig.

Insgesamt kann der Schaltkreis alle zum Empfang vom Bus benötigten Signaldiskriminatoren und Signalaufbereitungsmittel, die Sende- Busadertreiber und deren Koppelmittel, sowie alle Mittel zur Echtzeit-Busfehlererkennung und -behandlung nebst Mittel zur Anpassung der Sende- und Empfangsmittel an Fehlersituationen umfassen und in einer einzigen Halbleiterschaltung konzentrieren, welche somit ein Physical Layer zwischen dem Busprotokoll-Chip bzw. der Busprotokollfunktion des betreffenden Steuergerätes und dessen Microcontroller und den zwei Adern eines beispielhaft nach CAN-Standard gestalteten Busses repräsentiert. Der Schaltkreis verzichtet auf Software für den Betrieb des Microcontrollers zur Erkennung von Wecksignalen oder möglicher Busfehler sowie zur fehlerfallweisen Abschaltung bzw. Freischaltung der Sendemittel vom Bus sowie zur Umkonfiguration der Empfangs- und Sendmittel zwecks Übergang von der differentiellen Zweidraht-Betriebsweise auf eine nur eindrähtige über Masse und stößt mit diesem Konzept in Reaktionszeitbereiche vor, die Botschaftsverluste vermeiden lassen.

Mehrere Ausführungsbeispiele des integrierten Halbleiterschaltkreises sind in der Zeichnung dargestellt und in der nachfolgenden Beschreibung näher erläutert, wobei für den Begriff "integrierter Halbleiterschaltkreis" durchgängig die fachweltlich stehende Abkürzung "IC" verwendet wird. Wegen der Komplexität der von dem IC umfaßten und mehr oder weniger miteinander zusammenhängenden Funktionen ist die Beschreibung so gehalten, daß die Merkmale in bestverständlichem Zusammenhang erläutert werden, während die applikationsabhängig unterschiedlichen Verkörperungsalternativen ansprüchlich voneinander unterschieden werden.
- Fig. 1a: ein erstes Wirkschaltschema zur Veranschaulichung der Einbindungsumgebung des IC, wobei der IC einen Spannungsregler ansteuert;
- Fig. 1b: ein entsprechendes Wirkschaltschema, wobei der IC andere unter Busmanagement stromverbrauchend zu betreibende Elektroniken ansteuern kann;
- **Fig. 2**: eine schematische Veranschaulichung diverser, zu Funktionsblöcken beispielhaft zusammengefaßter Funktionen des IC 100 aus Figen. 1a und 1b;
- **Fig. 3a**: ein schematisches Wirkschaltbild der durch den Funktionsblock 131 bewirkten Abschlußbeschaltung der Bus-Adern;
- **Fig. 3b**: ein Wirkschaltbild analog zu Fig. 3a bei resistivem Ersatz eingeprägter Stromquellen und mit einer weiteren Schaltfunktion;
- **Fig. 4**: ein schematischer Wirkschaltbildauszug des IC im CAN-Netzverbund mit anderen derartigen IC in anderen Busteilnehmern in der Betriebsart "NORMAL";
- **Fig. 5**: ein schematischer Wirkschaltbildauszug des IC im CAN-Netzverbund mit anderen derartigen IC in anderen Busteilnehmern in der Betriebsart "SLEEP" oder "STANDBY" ohne Busfehler;
- **Fig. 6**: ein schematischer Wirkschaltbildauszug zur Erläuterung der Nichtweckbarkeit aus dem SLEEP-Mode eines symmetrisch terminierten CANs über CAN_L bei Unterbrechung von CAN_H;
- **Fig. 7**: ein schematischer Wirkschaltbildauszug zur Erläuterung der Weckbarkeit aus dem SLEEP-Mode eines asymmetrisch terminierten CANs über CAN_L bei Unterbrechung von CAN_H;
- **Fig. 8**: ein Schema des Spannungsverlaufs auf der asymmetrisch abgeschlossenen BusAder CAN_L bei einem Weckvorgang gemäß Fig. 7;
- **Fig. 9**: ein schematischer Wirkschaltbildauszug des IC im CAN-Netzverbund mit anderen derartigen IC in anderen Busteilnehmern in der Betriebsart "SLEEP" oder "STANDBY" mit Masseschluß an CAN_L;
- **Fig. 10**: ein schematischer Wirkschaltbildauszug des IC im CAN-Netzverbund mit anderen derartigen IC in anderen Busteilnehmern in der Betriebsart "SLEEP" oder "STANDBY" mit Versorgungsschluß an CAN_H;
- **Fig. 11**: eine schematische Illustration der von dem IC unmittelbar erkenn- und behandelbaren Busfehler;
- **Fig. 12a**: ein vereinfachtes Zeitdiagramm zur Veranschaulichung verschiedener Spannungsverläufe nach dem Anschalten an eine Betriebsstromquelle;
- **Fig. 12b**: ein vereinfachtes Blockschaltbild zur Veranschaulichung der betriebsartabhängig unterschiedlichen Auswertung des INTERRUPT-Signals des IC;
- **Fig. 13**: ein Gesamtblockschaltbild zur groben Veranschaulichung der einfachen Struktur eines mit dem IC ausgestatteten, busvernetzt betreibbaren Geräts;
- **Fig. 14**: eine schematische Illustration der monolithischen Verwirklichung des IC zusammen mit anderen Schaltkreisfunktionen im Sinne einer Large-Scale-Integration.

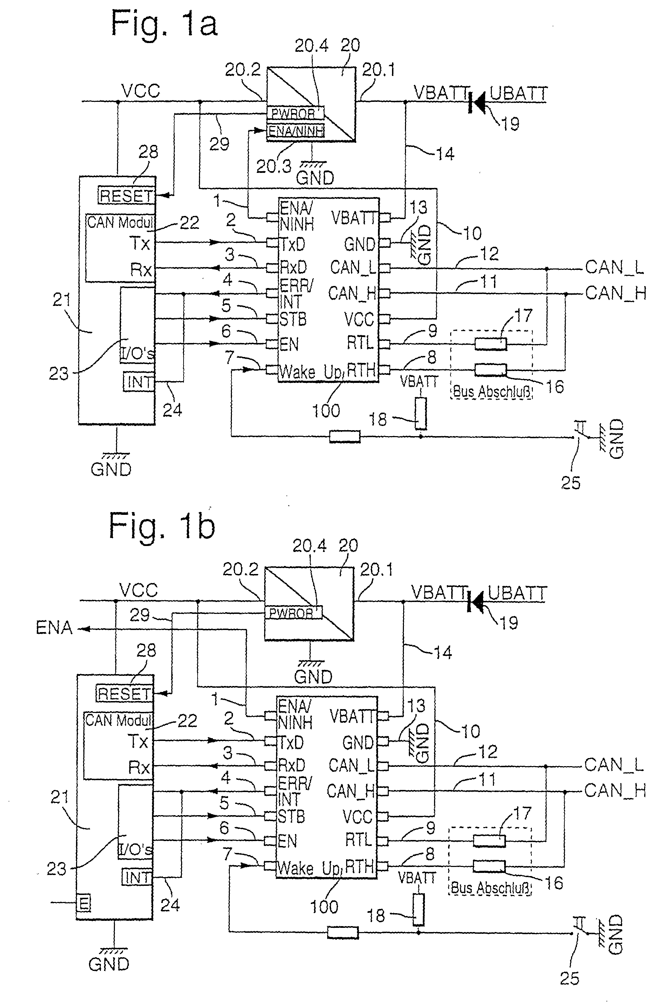

In der **Fig. 1a** ist der IC mit 100 bezeichnet und figürlich als 14-poliges SO-Bauelement versinnbildlicht. So kann er vorzugsweise auch praktisch ausgeführt sein. Gleichwohl kann es sich dabei aber auch um eine Anlage auf einem monolithischen Halbleiter-Chip handeln, die dort z.B. als Bestandteil einer umfänglicheren Halbleiterschaltung z.B. in der Art einer kompilierten Standardzelle deponiert ist.
Die Betrachtung als Bauteil soll insoweit nicht einschränken.

Der IC 100 ist zwischen die Bus-Adern CAN_H und CAN_L und das dem Microcontroller 21 des betrachteten elektronischen Gerätes zugeordnete Busprotokoll-Modul 22 geschaltet, entkoppelt letzteres also vom Bus CAN_H/CAN_L (Im folgenden bezeichnet CAN_H bzw. CAN_L die jeweilige Bus-Ader, CAN_H/CAN_L hingegen beide Adern, d.h. den Bus als physikalische Zweidrahtleitung).

Zu diesem Zweck sind CAN_H und CAN_L an entsprechende Anschlüsse 11 bzw. 12 des IC 100 geführt. Der IC 100 seinerseits ist über je einen Verbindungspfad 2 und 3 für zu sendende Daten TxD und zu empfangende Daten RxD mit dem Tx/Rx-Kommunikationsport des Busprotokoll-Moduls 22 verbunden. Der IC 100 steht ferner durch weitere Anschlüsse 8 und 9 über zwei Abschlußwiderstände 16 und 17 mit der entsprechenden Busader CAN_H bzw. CAN_L in Verbindung.

Des weiteren hat der IC 100 einen Eingang 7, der über einen Widerstand 18 mit logischem "H"-Potential, beispielsweise mit Versorgungspotential oder einem Potential, das nahe bei letzterem liegt, verbunden ist. Der Widerstand 18 ist andererseits über einen abgesetzten Schalter 25 mit Masse GND verbindbar.

Der IC 100 weist des weiteren wenigstens einen Ausgang 4 zur Abgabe eines Fehler- oder Unterbrechungssignals (ERROR bzw. INTERRUPT) für den Microcontroller 21 auf, der mit einem entsprechend belegten Eingang des I/O-Ports 23 und/oder einem entsprechenden Interrupt-Eingang 24 des Microcontrollers 21 verbunden ist, sowie zwei vice versa in entsprechender Weise aus dem I/O-Port 23 des Microcontrollers 21 angesteuerte Eingänge 5 und 6 für ein STANDBY-Signal (STB am Eingang 5) und ein TRANSMIT-ENABLE-Signal (EN am Eingang 6).

Für seine Stromversorgung weist der IC 100 einen Anschluß 13 gegen Masse GND auf, des weiteren einen Anschluß 14, an welchem das Speisepotential VBATT - vorzugsweise bezogen über eine Verpolungsschutzeinrichtung 19 aus einem übergeordneten Versorgungspotential UBATT - anliegt.

Der IC 100 weist des weiteren einen Steuerausgang 1 und einen Eingang 10 auf, letztwelcher hier beispielhaft mit dem Ausgang 20.2 eines von dem betrachteten elektronischen Gerät mitumfaßten elektronischen Spannungsregler 20 verbunden ist, an dessen Eingang 20.1 ebenfalls das Speisepotential VBATT geführt ist.

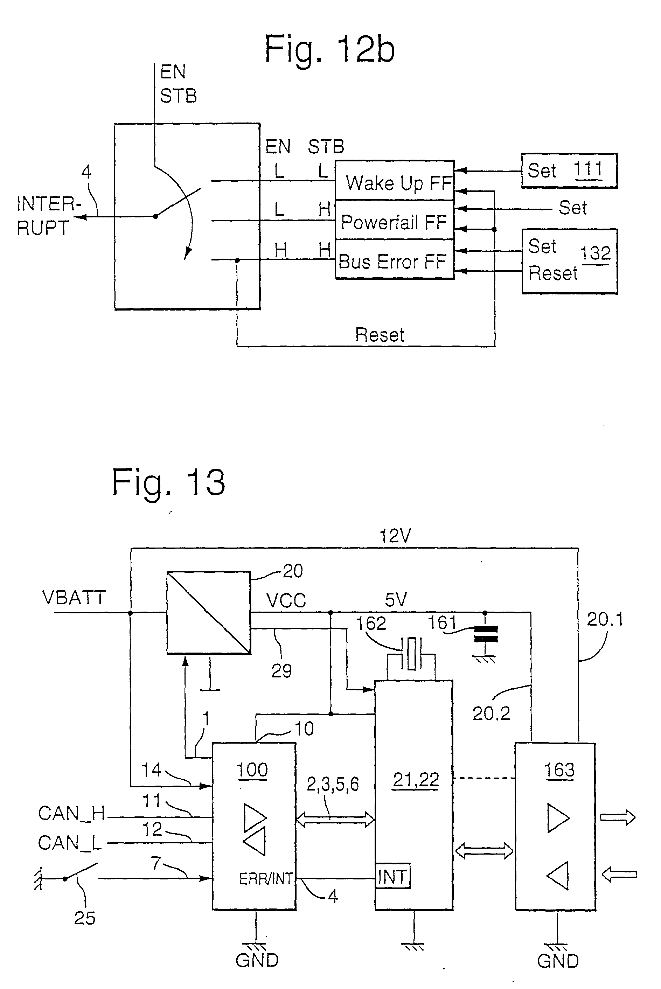

Der Ausgang 20.2 des Reglers 20 versorgt im übrigen den Microcontroller 21 und das Busprotokoll-Modul 22 sowie die übrige, in **Fig. 13** figürlich angedeutete Elektronik des den IC beinhaltenden elektronischen Geräts mit Betriebsstrom bei einer gegenüber VBATT um den Reglerabfall reduzierten Spannung VCC.

Der Regler 20 in **Fig. 1a** weist des weiteren einen Eingang 20.3 für ein (VOLTAGE REGULATOR) ENABLE- bzw. NOTINHIBIT- oder NOTENABLE- bzw. INHIBIT-Signal - im folgenden ENA/NINH bzw. NENA/INH abgekürzt - auf, der dort mit dem Steuerausgang 1 der IC 100 kommuniziert. Des weiteren weist der Regler 20 noch einen POWER ON RESET-Ausgang 20.4 - im folgenden PWROR abgekürzt auf, der über eine Leitung 29 mit einem Reset-Eingang 28 des Microcontrollers 21 kommuniziert.

Die IC-Umgebung gemäß **Fig. 1b** unterscheidet sich im wesentlichen nur dadurch, daß dort der Regler 20 einen Eingang 20.3 nicht aufweist und ein ENA/NINH-Signal der IC 100 über den Pfad 1 beispielsweise an andere Baugruppen des betrachteten Steuergerätes abgebbar ist.

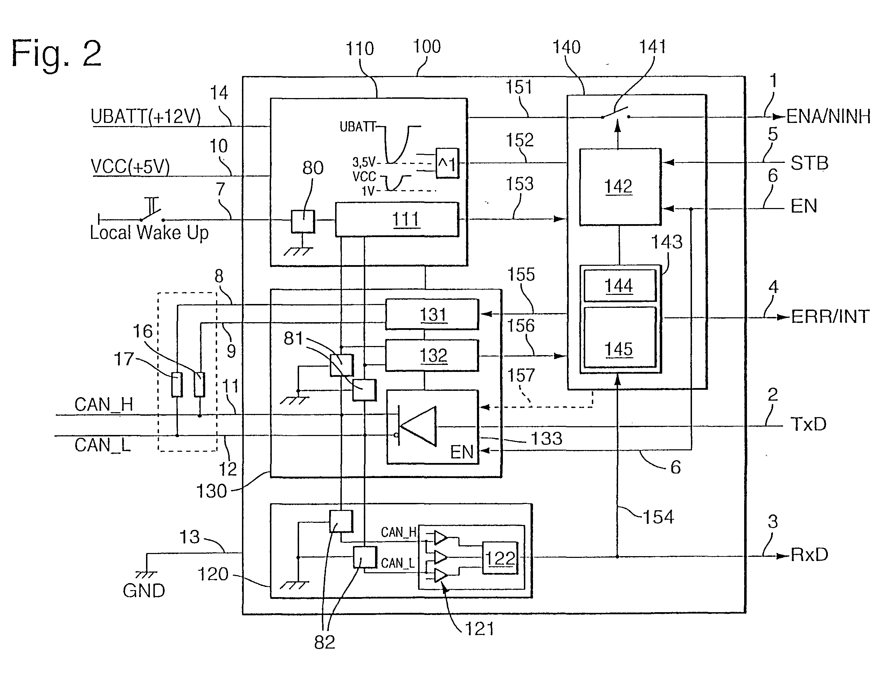

Zum nachfolgend besseren Verständnis des IC in einer so weit beschriebenen Geräteumgebung wird nun zuerst auf die innere Funktionsstruktur des IC 100 anhand **Fig. 2** bis **Fig. 8** näher eingegangen.

Gemäß **Fig. 2** ist der IC 100 beispielsweise in vier Blöcke 110, 120, 130 und **140** aufgeteilt; die für die interne Stromversorgung erforderlichen Speisepfade dieser Blöcke sind in **Fig. 2** aus Übersichtsgründen weggelassen. Die im folgenden beschriebene Verteilung von Detailfunktionen auf diese Blöcke ist nicht absolut zwingend und stellt keinerlei Beschränkung der Erfindung dar. Vielmehr hat sich diese Verteilung für eine erste Realisierung DER IC 100 als zweckmäßig erwiesen und wird in Abhängigkeit von unterschiedlichen Realisierungstechnologien innerhalb gewisser Grenzen variabel sein.

Eine wesentliche physikalische Funktion des IC 100 besteht in der elektrischen Isolation des Busprotokoll-Moduls 22 gegenüber CAN_H und CAN_L, auf welchen aus dem Applikationsfeld Surge- & Load Dump-Transienten auftreten können, welche das - je nach Fabrikationstechnologie mehr oder weniger empfindliche - Busprotokoll-Modul 22 (u.U. auch den gesamten Microcontroller 21) zerstören könnten. Zu diesem Zweck kann der IC 100 spezialisierte, hier nicht näher beschriebene Halbleitermittel umfassen, die vorzugsweise im Block 110 enthalten sein können, insbesondere Mittel zum Überspannungsschutz gegenüber der Speisepotentialschiene VBATT. Die Realisierung solcher Mittel sind dem Schaltkreisfachmann geläufig.

Der Block 110 umfaßt ferner die für die interne Stromversorgung sämtlicher Teilfunktionen aus dem am Anschluß 14 des IC 100 anliegenden Speisepotential VBATT erforderlichen Mittel. Ein beispielhaft durch den Block 140 geschleiftes Steuer- bzw. Schaltpotential (zur Generation eines ENA/NINH-Signals für Steuerungszwecke im betrachteten Busteilnehmergerät oder für den Spannungsregler 20 beim Beispiel gemäß Fig. 1a) wird dem Block 140 über einen Pfad 151 zur Verfügung gestellt.

Des weiteren umfaßt der Block 110 Detektormittel, welche einen Einbruch des am Anschluß 14 anliegenden Speisepotentials VBATT bis zur Unterschreitung eines ersten Grenzwertes VL1 (z.B. 3,5 Volt bei einem Kraftfahrzeug) und vorzugsweise auch einen Einbruch des am Anschluß 10 anliegenden Reglerausgangspotentials VCC bis zur Unterschreitung eines zweiten Grenzwertes VL2 (z.B. 1 Volt bei einem Kraftfahrzeug) erfassen, des weiteren optional die Gleichzeitigkeit bzw. zeitliche Abfolge des Eintretens solcher Unterschreitungen. Die Signale besagter Diskriminatoren werden durch logische Mittel zu einem Powerfail-Signal verknüpft, das über einen Pfad 152 an den Block 140 übermittelbar ist und dessen Bedeutung weiter unten noch näher ausgeführt wird.

Des weiteren umfaßt hier beispielhaft der Block 110 noch eine Weck-Erkennungs-Logik (WAKEUP Logic) 111. An diese Logik sind zum einen der oben beschriebene Anschluß 7 und zum anderen die an den Anschlüssen 11 und 12 liegenden Busadern CAN_H und CAN_L geführt. Diese Weck-Logik ist so beschaffen, daß sie sowohl ein analoges Wecksignal bzw. eine Wecksignalflanke vom Anschluß 7 als auch eine Weckbotschaft vom Bus wie auch immer in ein standardisiertes WAKEUP-Signal umsetzen kann, das über den Pfad 153 an den Block 140 (zur Auswertung in 145) ausgegeben wird.

Der Block 120 umfaßt vorzugsweise alle für das Auslesen des Busses erforderlichen Lesemittel 121, d.h. solche zur differentiellen und eindrähtigen Signalerfassung, einschließlich sämtlicher Fehlerbehandlungsund Logikmittel 122, die zum busfehlerabhängigen Wechsel der verschiedenen Lesearten (z.B. Zweidraht-, Eindraht gegen GND oder VCC, u.U. auch Eindraht gegen "Dead Wire" etc.) forderlich sind. Diese können vorzugsweise u.a. Bezugspegelvergleicher, Aderpegelvergleicher und/oder Vorzeichendiskriminatoren mit umfassen.

Der Block 120 kann so beschaffen sein, daß er zu einer fehlerresponsiven Einstellung und/oder Umkonfiguration und/oder Adaption seiner Empfangsmittel - unabhängig von den Sendemitteln und deren entsprechender fehlerresponsiven Einstellung und/oder Umkonfiguration und/oder Adaption **- selbsttätig und/oder selbständig** in der Lage ist, d.h. absolute Betriebs- und Funktionsautonomie aufweist (Fullsupported Receiver).

Das gewonnene digitale Botschaftssignal RxD geben nachgeschaltete Logikmittel 122 sowohl an den Anschluß 3 des IC 100 als auch über einen internen Pfad 104 an das Fehlersignalisierungs-Modul 143 im Block 140 ab.

Der Block 130 beinhaltet alle mit dem Signalflußpfad zusammenhängenden Mittel, die bei einer Realisierung zweckmäßigerweise nicht dem Empfangsblock 120 zugeordnet werden und insoweit in weitestem Sinne den Sendemitteln im Signalflußpfad zugeordnet sind.

Dies hängt damit zusammen, daß sowohl die Empfangsals auch die Sendemittel bevorzugt so ausgebildet und dimensioniert sind, daß sie - ohne externer Schutzmittel zu bedürfen - jeweils für sich autonom fehlertolerant gegenüber allen busweit applikationsspezifisch möglichen Fehlerzuständen, d.h. durch solche nicht beschädigbar sind. Insoweit sind die außer den Weckmitteln 111 und den Empfangsmitteln 120 am Bus noch liegenden Funktionsblöcke 131 und 132 bzw. deren Mittel hier beispielhaft dem Sendeblock 130 zugeordnet, der - also nur insoweit - Sendemittel in weitestem Sinne enthält; in engem Sinne sind Sendemittel von 133 umfaßt (Die in Abhängigkeit von der jeweils gewählten Realiserungstechnologie des IC 100 vorzusehenden Designdetails für schadlose Fehlertoleranz sind an sich bekannt).

Der Block 130 umfaßt den Funktionsblock "Abschlußumschaltmittel" 131 zur Um- und Hochohmigschaltung des Busabschlusses wie durch die Abschlußwiderstände 16 und 17 vorgegeben, einen Funktionsblock 132 "Busfehler-Erkennungsmittel" zur Diskrimination von Fehlerzuständen auf CAN_H/CAN_L, und zwar insbesondere auch Kurzschlüsse jeweils einer Busader nach Masse GND bzw. UBATT im Schlaf- bzw. Bereitschaftszustand (SLEEP/STANDBY), sowie Sendemittel in Form einer in obigem Sinne fehlertoleranten Endstufe 133, welche intern CAN_H- und CAN_L-Einzeltreiber enthält, die ausgangsseitig an die Anschlüsse 11 und 12 geführt sind.

Als wesentliche Elemente kann eine derartige Endstufe High- und Lowside-Schalter (Schalter, der auf einen hohen und niederen Spannungsregler Schalter) umfassen, deren Schaltausgänge über Koppeldioden an den Busadern liegen. Die Endstufe ist jedenfalls so ausgeführt, daß sie in Abhängigkeit von der Art eines auftretenden Busfehlers auf die jeweils noch bestmögliche Notkommunikationsweise eingestellt und/oder umkonfiguriert und/oder adaptiert werden kann (z.B. Wechsel auf Einaderbetrieb). Der Block 130 umfaßt auch erforderlichenfalls hierfür benötigte Mittel.

Optional kann die Endstufe ferner so ausgeführt sein, daß sie bei Auftreten eines Defekts bzw. Eigenfehlers des IC 100 vom Bus CAN_H/CAN-L automatisch freigeschaltet wird bzw. bleibt, etwa durch Sperrung ihres EN-Einganges. Eine solche Freischaltung kann von zwangsläufiger Art sein. Optional kann ferner insbesondere im Eigenfehlerfalle auch die Stromversorgung der Endstufe automatisch abschaltbar ausgeführt sein, wodurch insbesondere bei Fehlern im Bereich der Endstufe, ihres Eingangssignalpfades oder ihrer Zustandssteuerung ein Latchup des Bus-Netzes durch Fehlbestromung der Busadern vermieden wird. Die oben erwähnten Kopplungsdioden können in diesem Zusammenhang dann als Entkopplungsventile wirken.

Der Funktionsblock 132 steht mit dem Funktionsblock 131 in Verbindung, des weiteren mit dem Steuerungsblock 140. Er kommuniziert auch mit der Sendeendstufe 133. Letztere weist einen An-/Abschalteingang (TRANSMIT-ENABLE) EN auf, der mit dem Anschluß 6 des IC 100 kommuniziert.

Die vorgenannte Möglichkeit einer Zwangsfreischaltung der Endstufe 133 vom Bus CAN_H/CAN_L kann z.B. so realisiert sein, daß der Eingang EN der Endstufe 133 im Falle eines Defekts verriegelbar ist, so daß sich das Sendesignal TxD auf den Bus nicht mehr auswirken kann. Eine solche Zwangsfreischaltung kann auch für den Fall vorgesehen sein, daß das Potential VBATT und/oder VCC unter einen vorbestimmten Schwellwert abfällt, wodurch eine unerwünschte inaktive Bürdelast am Bus vermieden wird.

Der Steuerungsblock 140 erfüllt ebenfalls mehrere Funktionen. Hierzu umfaßt er - als Mittel zur Initialisierung des Microcontrollers 21 - einen gesteuerten Schalter oder ein Gatter 141 zur Abgabe am Anschluß 1 von 100 eines Abschalt- bzw. Einschalt-Signals ENA/NINH für den Spannungsregler 20, einen Funktionsblock 142 zur Erkennung und Einstellung der vom Microcontroller auferlegten Betriebsarten "Schlafen", "Bereitschaft", Nur-Empfang" und "Normal" (entsprechend "Senden und Empfang" (SLEEP, STANDBY, RECEIVE ONLY, NORMAL) der Einrichtung, und ein Fehlersignalisierungs-Modul 143.

Letzteres besteht vorzugsweise aus einem Funktionsblock 144 zur Auswertung von Busfehlern in ein (BUS-) ERROR-INTERRUPT-Signal und einem Funktionsblock 145 zur Erzeugung eines WAKEUP-INTERRUPT-Signals in Abhängigkeit von einem Wecksignal und/oder eines POWERFAIL-INTERRUPT-Signals als Folge eines Versorgungsmangelzustandes wie weiter unten näher erläutert. Wie ebenfalls weiter unten i.V. mit **Fig. 12b** erläutert enthält der Block 143 zwecks Generation dieser verschiedenen Signale beispielsweise wenigstens drei Flag-Flipflops für ein WAKEUP-, ein POWERFAIL und ein BUS ERROR Flag; diese Flags werden betriebsartabhängig als INTERRUPT ausgelesen.

Zur Erkennung der verschiedenen Betriebsarten weist der Funktionsblock 142 hier beispielhaft einen zwei Bit breiten Port auf, bestehend aus Eingang 5 für STB (STANDBY) und Eingang 6 für EN (TRANSMIT-ENABLE), wobei letzterer erwähntermaßen mit dem gleich gekennzeichneten An-/Abschalteingang der Endstufe 133 verbunden ist. Die Vorrichtung ist selbstverständlich nicht auf die hier beispielhaft vier durch zwei logische Pegel binär selektierbare Betriebsarten des IC 100 beschränkt.

Der Funktionsblock 142 ist ferner mit dem Fehlersignalisierungs-Modul 143 verbunden, letztwelches hier beispielhaft einen einzigen, an den Anschluß 4 des IC 100 geführten Ausgang ERROR/INTERRUPT - im folgenden auch abgekürzt ERR/INT - für ein Fehleranzeige- bzw. Unterbrechungssignal sowie einen Eingang aufweist, dem über den bereits erwähnten Pfad 154 das vom Block 120 ausgegebene digitale Botschaftssignal zuführbar ist. Durch eine Zuordnung zu verschiedenen Betriebszuständen können einem ERR/INT-Signal an Anschluß 4 unterschiedliche Bedeutungen zugewiesen werden.

Ohne Beschränkung der Allgemeinheit können auch wenigstens zwei designierte Ausgänge ERROR und INTERRUPT vorgesehen sein, deren ERROR- bzw. INTERRUPT-Signale dann nicht betriebsartabhängig interpretiert zu werden brauchen, sofern eine entsprechend größere Anzahl von Anschlüssen für den IC 100 tolerierbar ist. Die aufgrund der hier beispielhaften Begrenzung der Anschlußzahl auf insgesamt vierzehn somit erforderliche Uminterpretation des am Ausgang 4 abnehmbaren Signals wird weiter unten i.V. mit Figen. **12a** und **12b** noch erläutert.

Des weiteren umfaßt die Vorrichtungs auch, daß im Block 143 das ERR/INT-Signal als Resultat einer logischen Verknüpfung beispielsweise eines internen ERROR-Ergebnissignals der Busfehler-Auswertungsmittel 144 und eines internen Ergebnissignals der Auswertungsmittel 145 für Weck- und/oder Fehlspannungsereignisse gewonnen wird, beispielsweise hinsichtlich des Unterschreitens eines Grenzwertes für die Betriebsspannung VBATT des IC 100.

Die Funktion des so weit beschriebenen IC im nachfolgend zugrundegelegten Zusammenspiel mit den aus Fig. 1a ersichtlichen Komponenten ist folgende.

Vermöge vom Spannungsregler 20 mitumfaßter Mittel erzeugt dieser an seinem Ausgang 20.4 nach jedem Einschalten ein PWROR-Signal und gibt dies über die Verbindung 29 an einen Rücksetzeingang 28 des Microcontrollers 21 ab, um dessen ordnungsgemäße Initialisierung nach Aufbau seiner Speisespannung VCC sicherzustellen.

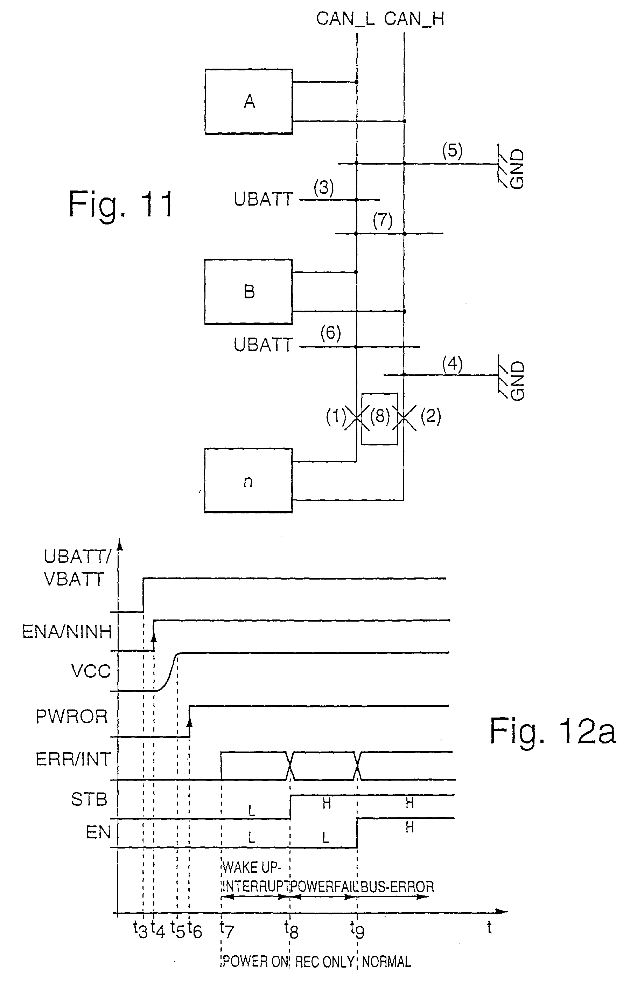

Da die Einschaltung des Spannungsreglers über ENA/NINH vonseiten des IC 100 ausgelöst wird, kann so durch Überwachung im IC 100 der Zeitspanne zwischen der den Regler 20 aktivierenden ENA/-NINH-Flanke und eines der EN- und STB-Bits für die Einstellung der Initialbetriebsart des IC 100 (also entsprechend (t₈ - t₄) in **Fig. 12a**) eine Prüfung der Initialisierungsstrecke Regler-Microcontroller auf Fehlerfreiheit erfolgen.

Die an den Anschlüssen 5 (STANDBY/STB) und 6 (TRANS-MIT ENABLE/EN) anliegenden Selektions-Bits selektieren eine der hier beispielhaft vier Betriebsarten **SLEEP, STANDBY, RECEIVE ONLY,** und **NORMAL** des IC 100. Diese Betriebsarten werden im Rahmen einer übergeordneten Bus-Management-Software zum Betrieb des Busnetzes verwaltet und explizit von der Applikations-Software des betreffenden elektronischen Gerätes, in welchem der betrachtete IC 100 sich befindet, initiiert.

In der Betriebsart **SLEEP** ist der Schalter bzw. das Gate 141 so aktiviert, daß das vom Steuerausgang 1 an den Steuereigang 20.3 des Spannungsreglers ausgegebene logische Signal ENA/NINH zur Abschaltung des Reglers 20 führt. Aus Stromersparnisgründen ist das logische Potential am Steuerausgang 1 in dieser Betriebsart beispielsweise "L". Infolge der Abschaltung des Reglers 20 sind der Microcontroller 21 und das Busprotokoll-Modul 22 ohne Speisespannung VCC und deshalb stromlos. Als unmittelbare Folge kann an/in den/die beiden Eingänge/n 5 (STB) und 6 (EN) stationär nur das Potential Null anstehen bzw. kein Strom fließen, entsprechend also dem Selektionswort "LL" am I/O-Port 23 des Microcontroller 21 für die beiden Signale STB und EN in der Betriebsart SLEEP.

Am IC 100 liegt hierbei also nur die Speisespannung VBATT an, während die Spannung VCC am Anschluß 10 Null ist. Ein - minimaler - Stromverbrauch geschieht in diesem Zustand also nur durch den IC 100 von der Schiene VBATT aus; da VCC = Null, ist die gesamte VCC-versorgte Elektronik des betrachteten Steuergerätes stromlos.

In der Betriebsart SLEEP muß der IC 100 nur eine definierte Minimalaktivität auf CAN_H/CAN_L und/oder am Anschluß 7 quasi-statische Weck-Anforderungen z.B. von einem Schalter 25 erkennen, der aus Stromersparnisgründen hier als Arbeitskontakt nach Masse GND ausgebildet ist, sowie bei Bedarf das ENA/NINH-Signal generieren, kommt also mit 30...500µA Versorgungsstrom aus.

Diese Betriebsart kommt somit für Steuergeräte in Frage, bei denen eine gewisse Zeit duldbar ist, die zwischen dem Aufbau des Potentials VCC und dem Anfachen der internen Clock-Frequenz und der Initialisierung des Watchdogs (Überwachungs-Einheit) des Microcontrollers 21 verstreicht (Größenordnung 25 ms). Durch die unter solchen Betriebsbedingungen mit der IC 100 mögliche Minimierung des Stromverbrauchs eines batteriegestützten CAN-Bus-Netzes in Zeiten seiner Kommunikationsruhe wird die Verfügbarkeit des Netzes ganz beträchtlich erhöht.

Im Falle eines Weckens durch Aktivität auf CAN_H/CAN_L wird eine solche Aktivität von der Weck-Logik 111 in 110 sensiert, was im Steuerungsblock 140 zur Ansteuerung des Schalters oder Gatters 141, damit zur Aktivierung des Spannungsreglers 20, damit zu Einschaltung von VCC, damit zur Aktivierung des Bus-Protokoll-Chips 21, des Clock-Oszillators des Microcontrollers 21 und seines hier nicht figürlich ausgeführten Watchdogs und ggfs. - über Anschluß 3 - zur Abgabe von Botschaftsdaten an den Rx-Eingang des Busprotokoll-Moduls 22 führt.

Im Falle eines lokalen Weckens durch den Schalter 25 wird durch dessen Betätigung der Eingang 7 auf "L" gesetzt, was vermittels der Weck-Logik 111 und des Pfades 103 ebenfalls zur Ansteuerung des Schalters oder Gatters 141 und somit zum gleichen Weck-Ergebnis führt.

Die Betriebsart NORMAL kann aus der Betriebsart SLEEP durch Sensierung einer WAKEUP-Anforderung entweder über den Bus - also vermittels der Weck-Erkennungslogik 111 - oder als lokale Anforderung durch den Schalter 25 erfolgen.

Die Betriebsart STANDBY ist dadurch gekennzeichnet, daß das vom IC 100 an den Spannungsregler 20 abgegebene ENA/NINH-Signal letzteren einschaltet bzw. eingeschaltet hält. Folglich ist dadurch die Speisespannung VCC auch in der Betriebsart STANDBY präsent.

Infolgedessen wird in der Betriebsart STANDBY sowohl das Busprotokoll-Modul 22 als auch die übrige Elektronik des betrachteten Geräts in Betrieb gehalten. Infolgedessen kann vom Microcontroller 21 an den Eingang 5 des IC 100 der von "L" abweichende STANDBY-Signalpegel "H" ausgegeben werden.

Die Betriebsart STANDBY kommt somit für Geräte bzw. Fälle infrage, bei denen die gewisse, im Falle der Betriebsart SLEEP duldbare Zeit (Größenordnung 25 ms) **nicht** verloren werden darf, bis der Bus-Protokoll-Chip operationsfähig wird. Praktische Beispiele hierfür wären z.B. die Zylinderneutralfahrt an einer Druckmaschine oder die Infrarot-Fernbedienung der Türverriegelung eines Kraftfahrzeugs, welche zwecks Vermeidung von Ansprechhemmungen und/oder Botschaftsverlusten eine Empfangsbereitschaft binnen kürzester Zeit verlangen.

Die Aktivierung des IC 100 in die Betriebsarten STANDBY, RECEIVE ONLY und NORMAL ist insgesamt letztlich auf dreierlei Weisen bewirkbar: Vom Microcontroller 21 aus über 4, 5 und 6, über den Bus CAN_H, CAN_L und durch lokale Weck-Anforderung etwa durch einen Schaltkontakt.

Beim Umfeld gemäß **Fig. 1a** ist in allen drei Fällen wesentlich, daß bezüglich des Aufbaues des Einschaltsignales ENA/NINH beim Wecken die beiden Steuerbits EN und STB zunächst den logischen Zustand "L" haben, während für das Aufrechterhalten des Einschaltsignales ENA/NINH eines dieser Bits den logischen Pegel "L" verlassen haben, d.h. "H" sein muß. Die Bereitstellung des Einschaltsignales ENA/NINH ist also in diesem Falle in eine Initialisierungsphase unter Kontrolle durch den IC 100 (solange der Microcontroller 21 noch nicht vollständig stromversorgt bzw. fertig initialisiert ist) und eine Haltephase unter Kontrolle durch den Microcontroller unterteilt.

Aus diesem Verständnis folgt jenes der Funktionen und Anwendungsmöglichkeiten des IC 100 im abgewandelten Geräteumfeld gemäß **Fig. 1b** von selbst. Jene Situation betrifft eine Applikation, in dem der Microcontroller 21 nicht abgeschaltet werden darf, weil er z.B. in einem Lowpower- oder Shutdown-Mode überwachungsfunktionen bei - zwecks Stromersparnis - reduzierter Taktfrequenz und oder Aktivität zyklisch erfüllen muß, aber mangels Duldbarkeit eines auch nur geringen Verzugs lokal sehr schnell hochfahrbar sein muß. Der Regler 20 ist deshalb hier nicht abschaltbar. In einem solchen Falle kann das zu ENA/NINH komplementäre Abschaltsignal NENA/INH bedarfsweise zur Abschaltung von in der Betriebsart SLEEP überwachungsunrelevanten Schaltungsbereichen des betrachteten Steuergerätes herangezogen werden, wie hier durch den Weiterleitungspfeil an 1 versinnbildlicht. Es versteht sich, daß auch durch diese abgewandelte Art der Energieeinsparung vermittels des IC 100 in einem batteriegestützten CAN-Netz dessen Verfügbarkeit beträchtlich erhöht werden kann.

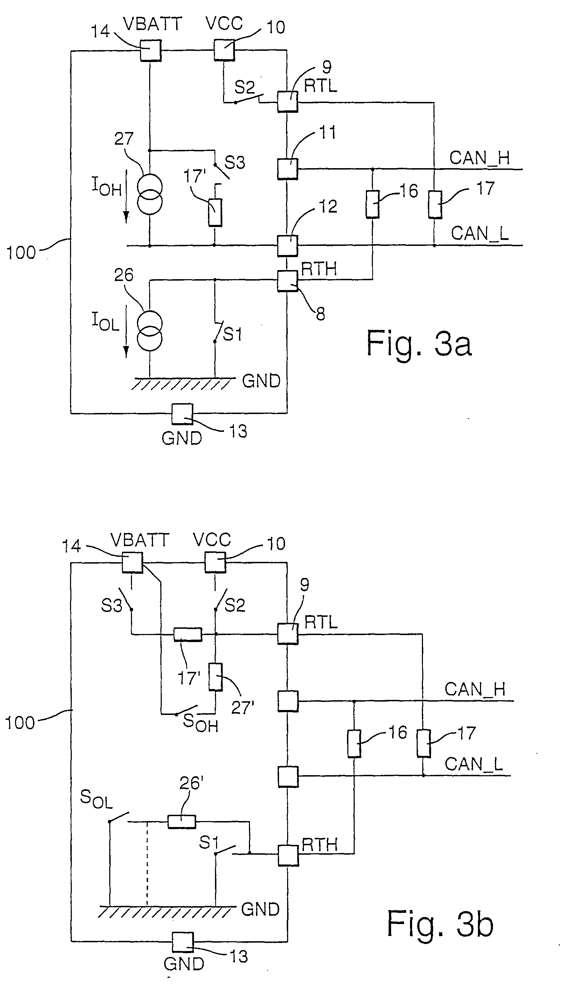

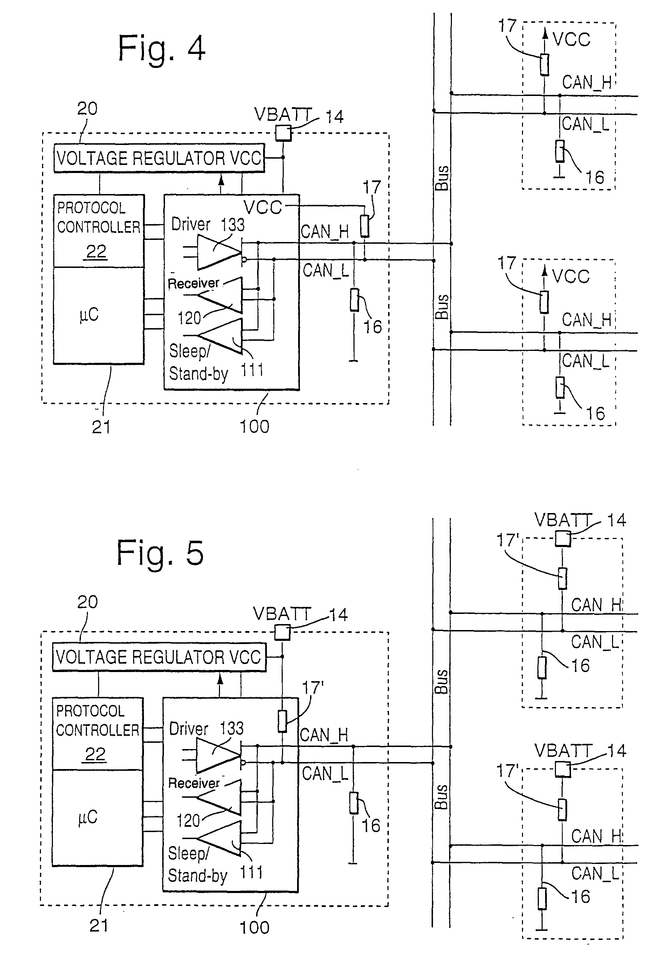

Anhand **Fig. 3a** bis **Fig. 7** wird nunmehr die Wirkungsweise des Funktionsblocks 131 im Hinblick auf die an CAN_H und CAN_L angeschalteten Abschlußwiderstände 16 und 17 erläutert. Dabei veranschaulichen **Fig. 3a** und **Fig. 4** die Abschlußbeschaltung CAN_H und CAN_L im normalen, aktiven Betriebszustand (Senden und Empfangen) ohne Vorliegen eines Busfehlers.

Gemäß **Fig. 3a** enthält der Funktionsblock 131 u.a. einen Schalter S₁, der den Anschlußpunkt 8 mit Masse GND verbinden und dadurch CAN_H über den externen Abschlußwiderstand 16 an Masse schalten kann, einen Schalter S₂, der den Anschlußpunkt 9 mit dem geregelten Speisepotential VCC verbinden und dadurch CAN_L über den externen Abschlußwiderstand 17 an VCC anschalten kann, sowie wenigstens einen weiteren Schalter S₃, der CAN_L über einen internen Widerstand 17' mit dem höheren Speisepotential VBATT verbinden kann. Dabei sind der Schalter S₁ durch eine Stromquelle 26 mit Einprägstrom I_{OL} und der Schalter S₃ durch eine Stromquelle 27 mit Einprägstrom I_{OH} überbrückt. Die Ströme I_{OH} und I_{OL} sind sehr gering und können einheitlich in der Größenordnung von z.B. 1...20 µA liegen.

Ohne Beschränkung der Allgemeinheit können die Stromquellen auch durch hochohmige Widerstände zwischen z.B. 50...250 kΩ ersetzt sein, wie in **Fig. 3b** veranschaulicht.

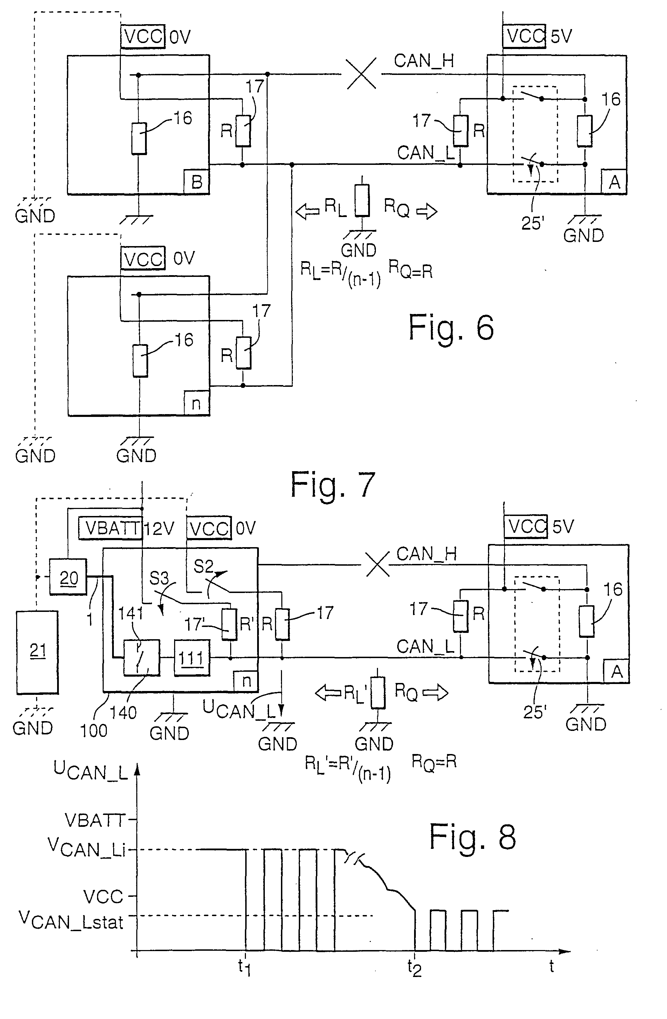

Die Abschlußwiderstände 16 und 17 sind gleich und werden in Abhängigkeit von der vorbekannten Anzahl der Bus-Teilnehmer festgelegt. Normalerweise können sie z.B. 560 Ω ± 5% bei einem größeren Bus-Netz und maximal 15 kΩ ± 5% bei einem kleinen Busnetz aufweisen. Die Niederohmigkeit in größeren Busnetzen folgt einerseits aus der höheren kapazitiven Bürde größerer Netze und andererseits aus der Forderung ausreichender Unterdrückung unerwünschter Einstreuungen statischer und elektromagnetischer Art in einem räumlich weitverzweigten Busnetzwerk. Der vorzugsweise in der IC 100 integrierte interne Widerstand 17' weist in einem Busnetz, das für rund 20 Teilnehmer konzipiert ist, einen Wert in der Größenordnung von 12 kΩ auf, basierend auf einem Widerstand 17 in der Größenordnung von 600 Ω für Normalabschluß. Näheres zur Dimensionierung siehe **Fig. 6** und **Fig. 7** und zugehöriger Beschrieb. In der Praxis kann ein ON-Widerstand der Schalter S₁ bis S₃ bis zu 200 Ω tolerabel sein.

In der Betriebsart NORMAL (Senden und Empfang) sind die Schalter S₁ und S₂ geschlossen, S₃ hingegen offen, d.h. CAN_L liegt über den Widerstand 17 an VCC und CAN_H liegt über den Widerstand 16 an Masse GND. So lange kein Busfehler vorliegt, kann der Einfluß der Ströme I_{OH} und I_{OL} vernachlässigt werden.

Insoweit veranschaulicht **Fig. 4** nur die wesentlichen Teile eines CANs mit beispielhaft drei busvernetzten Geräten A, B und C, d.h. das durch entsprechende Stellung der Schalter S₁ bis S₃ dabei wirksame Netzschaltbild im Betriebszustand **NORMAL**. Es wirken also jeweils alle externen Abschlußwiderstände 16 und 17 der Busteilnehmer A bis C an CAN_H bzw. CAN_L parallel.

Hinsichtlich **Fig. 3a** sind in den Betriebsarten SLEEP und STANDBY die Schalter S₁ und S₃ geschlossen, S₂ hingegen offen, d.h. CAN_L liegt nunmehr über den höheren internen Widerstand 17' am höheren Potential VBATT und CAN_H liegt über den Widerstand 16 an Masse GND. So lange kein Busfehler vorliegt, kann der Einfluß der Ströme I_{OH} und I_{OL} auch hier vernachlässigt werden.

In entsprechender Weise veranschaulicht **Fig. 5** nur die wesentlichen Teile desselben CANs im Betriebszustand **SLEEP** oder **STANDBY,** d.h. das durch entsprechende Stellung der Schalter S₁ bis S₃ dabei wirksame Netzschaltbild. Es wirken also jeweils die externen Abschlußwiderstände 16 und die internen Abschlußwiderstände 17' der Busteilnehmer A bis C an CAN_H bzw. CAN_L parallel.

Es liegt also in den Betriebsarten SLEEP und STANDBY in allen am Netz liegenden Geräten ein asymmetrischer Busabschluß vor, indem sich zum einen die Werte der Widerstände 16 und 17' je nach Anzahl der Busteilnehmer etwa um einen dieser Anzahl entsprechenden Faktor unterscheiden und zum anderen die Widerstände 17' anders als die Widerstände 17 nicht an VCC als Bezugspotential, sondern an der höheren Speisespannung VBATT liegen. Durch diese Maßnahme wird die Weckfähigkeit des CANs über CAN_L auch noch dann sichergestellt, wenn eine Unterbrechung von CAN_H vorliegt, wie nachfolgend anhand **Fig. 6** bis **Fig. 8** erläutert.

In **Figen**. **6** und **7** versinnbildlicht der im Gerät A symbolisierte Schalter 25' den elektronischen Schalter, der die Ader CAN_L im Aktivierungsfalle von ihrem hohen rezessiven Pegel auf den nur wenig über Masse GND liegenden aktiven Pegel des CAN_L schaltet. Bezüglich der Pegelverhältnisse wirkt der Schalter 25' also nicht nur ähnlich wie der bereits erwähnte Schalter 25 nach Masse GND am lokalen Weckeingang 7 der IC 100. Letztlich wird er innerhalb der IC 100 auch wirksam infolge einer Aktivierung eines externen, lokalen Weck-Schalters 25.

Gemäß **Fig. 6** sind in der Betriebsart SLEEP die Spannungsregler 20 in den Busteilnehmern A bis n abgeschaltet, wodurch VCC als Terminierungspotential ausfällt, weil infolge Fehlens von VCC alle VCC-Schienen geräteintern virtuell an Masse GND liegen. Wäre hierbei CAN_L durch Widerstände 17' mit einem Wert entsprechend dem der Widerstände 17 und 16 gegen VCC - im SLEEP-Zustand also virtuell gegen Masse GND - terminiert, wäre beispielsweise bei unterbrochener Busader CAN_H ein Wecken über die Busader CAN_L nicht möglich.

Ein Widerstand 17 mit dem Wert R - als Weckquellwiderstand R_{Q} - könnte vom Potential VCC im weckenden Busteilnehmer A aus die Bus-Ader CAN_L gegen den Gesamtlastwiderstand von R_{L} = R/(n-1) (also z.B. 1/20 R aufgrund 20 parallel wirkender Widerstände 17 desselben Wertes R in einem Busnetz mit 21 Teilnehmern) an Masse nur um einen kleinen Bruchteil von VCC auf ein Potentail im Bereich von 100...200 mV anheben, was nicht ausreichte, um eine solche Weckbotschaft störsicher zu lesen. Diese Problematik wächst mit der Zahl der Netzteilnehmer und parasitären Masseoffsets (durch Stromschleifen) z.B. längs ausgedehnten Anlagen oder Fahrzeugen.

Die Maßnahme gemäß **Fig. 7** schafft hier Abhilfe. Der Widerstand 17' weist hier einen erheblich größeren Wert auf, der etwa einem Vielfachen entsprechend der erwartbaren Anzahl n von Geräten am Bus entspricht (also z.B. ca. 12 kOhm, wenn der Widerstand 17 ca. 600 Ω in einem Busnetz mit etwa 20 Teilnehmern entspricht). Das weckende Gerät A "sieht" folglich den insgesamt größeren Lastwiderstand R_{L}' = R'/(n-1).

Außerdem liegt dieser Widerstand 17' nicht an dem im Betriebszustand SLEEP verschwindenden Potential VCC (normalerweise ca. 5 Volt), sondern - vermittels S₃ anschaltbar - an dem wesentlich höheren, auch in der Betriebsart SLEEP verfügbaren Speisepotential VBATT (beispielsweise ca. 12 Volt).

Durch diese Maßnahme wechselt also die Source-Funktion des in **Fig. 6** weckenden Gerätes A über in eine Source-Funktion der Vielschaft aller zu weckenden Geräte B bis n am Bus, während dem weckenden Gerät A diesbezüglich eine Sink-Funktion verbleibt.

Der Spannungsverlauf auf der Ader CAN_L des so im SLEEP-Zustand asymmetrisch abgeschlossenen CANs ab dem Beginn zur Zeit t₁ eines Weckvorganges über diese Ader ist in **Fig. 8** veranschaulicht. Initial hat der Spannungshub auf CAN_L einen Wert V_{CAN_Li} zwischen VCC und VBATT. Ausgelöst durch die (bei diesem großen Spannungshub störfrei erkennbare) Weckbotschaft über CAN_L erzeugt in jedem der am Bus liegenden Teilnehmer-Geräte A bis n der IC 100 das ENA/NINH-Signal, welches einerseits über die bereits erwähnten Funktionsblöcke 111 und 140 samt Schalter bzw. Gatter 141 alle Spannungsregler 20 in diesen Geräten einschaltet und damit VCC in jedem Gerät verfügbar macht.

Andererseits wird bei Verfügbarkeit von VCC mittels des Schalters S₃ die Verbindung zwischen CAN_L und dem Speisepotential VBATT über den hochohmigen Abschlußwiderstand 17' aufgetrennt und stattdessen CAN_L vermittels S₂ durch den normalen Abschlußwiderstand 17 mit dem niedrigeren Speisepotential VCC verbunden. Es ist also ersichtlich, daß zu einem Zeitpunkt t₂ der Abfall des Spannungshubes am Bus über Masse GND auf einen stationären Wert V_{CAN_Lstat} abgeschlossen ist, wobei die Zeitspanne (t₂ - t₁) im wesentlichen der Über-Alles-Response-Zeit des IC 100 und des Reglers 20 auf ein Wecksignal ist.

An dieser Stelle sei angemerkt, daß innerhalb eines Busnetzes einzelne Busteilnehmer durchaus in der Betriebsart STANDBY und andere im SLEEP-Zustand verharren können. Ein Wecken anderer Busteilnehmer könnte hierbei auch durch ein in der Betriebsart STANDBY befindliches Gerät erfolgen, wenn hierfür im Sinne des symbolischen Schalters 25' der Lowside-Schalter der Endstufe 133 aktivierbar ist.

Ein Beispiel für die Anwendung der Betriebsart STANDBY ist z.B. der (wartende) Negativeinzug eines Entwicklungsautomaten oder der Infrarotempfangsteil einer Schließanlage eines Fahrzeugs, der ununterbrochen auf das Eintreffen des Filmzulaufs bzw. codierten Entriegelungssignals warten muß. In diesem Zustand ist bei einem solchen Gerät der Regler 20 eingeschaltet, VCC folglich präsent, so daß der Zeitverbrauch (t₂ - t₁) bis zu einer Response über den Bus größtenteils entfällt.

Ohne Beschränkung der Allgemeinheit kann der Funktionsblock 131 auch ein Wirkschema gemäß **Fig. 3b** aufweisen; in diesem Falle wirken die Widerstände 17 und 17' jeweils in Serie. Der Widerstand 17' wäre insoweit am Anschluß 9 des IC 100 wirksam. Grundsätzliches ändert sich dadurch an der Netzbetrachtung gemäß **Figen. 4** bis **11** jedoch nicht.

Des weiteren ist in **Fig. 3b** veranschaulicht, daß der mit der Stromquelle 26 in **Fig. 3a** korrespondierende Widerstand 26' gleichwohl mit Masse GND auch über einen besonderen Schalter S_{OT} freischaltbar verbunden sein kann, um beispielsweise i.Z. mit der automatischen Anpassung der Pegelkomparation der Empfangsmittel 120 und/oder der Sendeendstufe 133 im Falle eines Busfehlers oder bei externen Diagnosemessungen am Bus eine Testfunktion zu ermöglichen. Diese Wirkung könnte bei einer Lösung gemäß **Fig. 3a** auch durch eine Abschnürsteuerung der Stromquelle 26 realisiert werden.

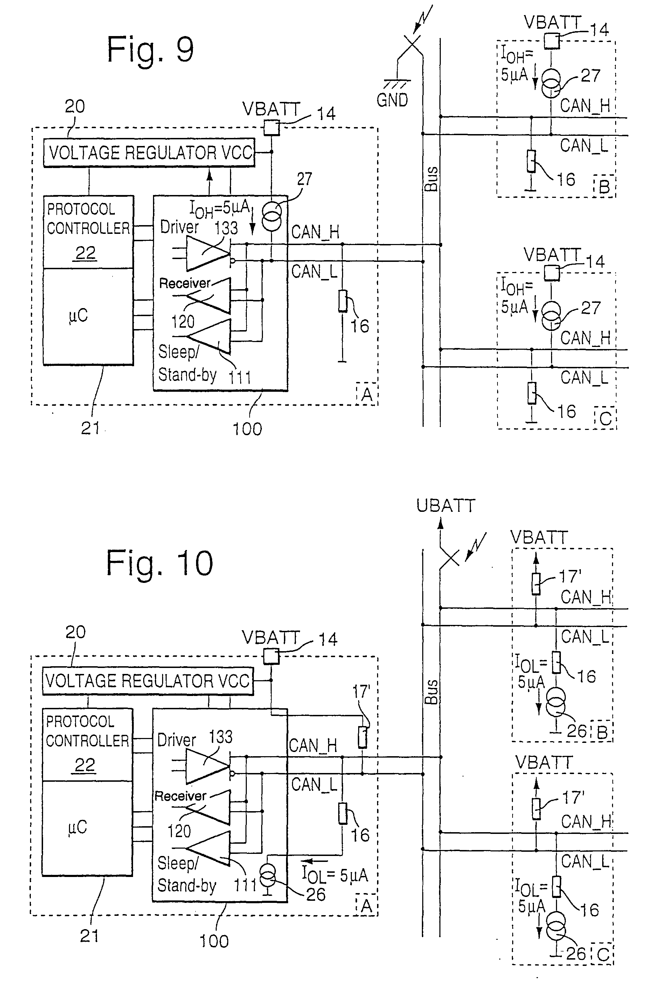

Auf der Basis des Wirkschaltbildes gemäß **Fig. 3a** veranschaulicht nun **Fig. 9** die Verhältnisse im weiten Netzverbund bei Kurzschluß der Bus-Ader CAN_L nach Masse GND in der Betriebsart "SLEEP" oder "STANDBY".

Bei einem Widerstand 17' von z.B. 12 kΩ träte in diesem Fall in einem beispielhaft 20 Teilnehmer umfassenden Netz busweit ein resultierender Leckwiderstand von 600 Ω zwischen dem internen Geräte-Speisepotential VBATT von z.B. 12 Volt und Masse GND auf, d.h. busweit ein Leckstrom von 20 mA, der zu einer raschen Entladung einer Batterie als Versorgungsquelle führen könnte.

Im Falle eines solchen Kurzschlusses wird dieser deshalb vom oben erwähnten Funktionsblock 132 (Fehlererkennungs-Modul) des IC 100 in jedem einzelnen Busteilnehmer erkannt, was im Funktionsblock 131 bewirkt, daß jeweils der Schalter S₂ öffnet und der Schalter S₃ schließt, wodurch die Stromquellen 27 wirksam werden. Deren verhältnismäßig geringer Strom von z.B. nur 5µA ergibt bei 20 Geräten busweit nur 0,1 mA Leckstrom. Dieser Strom ist klein genug, daß er in der natürlichen Selbstentladungsrate beispielsweise einer Notstrom-oder Starterbatterie völlig untergeht.

Entsprechend veranschaulicht **Fig. 10** die Verhältnisse im Netzverbund bei Kurzschluß der Bus-Ader CAN_H mit einer Bordnetzschiene an UBATT in der Betriebsart "SLEEP" oder "STANDBY" (Versorgungsbordschluß).

Bei einem Widerstand 16 von z.B. 600 Ω träte in diesem Fall in einem beispielhaft 20 Teilnehmer umfassenden Netz busweit ein resultierender Leckwiderstand von 30 Ω zwischen z.B. der Bordnetzklemme 30 mit ca. 13 Volt und Masse GND auf. Dies hätte busweit einen Gesamtleckstrom von 430 mA zur Folge, der zu einem noch rascheren Abbau der beispielhaft zum Starten der Brennkraftmaschine benötigten Batterieladung führte.

Tritt ein solcher Kurzschluß auf, wird er von dem oben erwähnten Fehlererkennungs-Modul 132 des IC 100 in jedem einzelnen Busteilnehmer erkannt. Dies bewirkt im Funktionsblock 131, daß jeweils der Schalter S₁ geöffnet wird, wodurch die Stromquellen 26 wirksam werden. Deren verhältnismäßig geringer Strom von z.B. nur 5µA ergibt bei 20 Geräten busweit auch nur vernachlässigbare 0,1 mA Leckstrom.

Bei Vorliegen eines Kurzschlusses von CAN_H nach UBATT oder GND oder CAN_L nach Masse GND oder UBATT besteht bezüglich der Umschaltung des Busabschlusses vermittels der Schalter S₁ bis S₃ kein grundsätzlicher Unterschied in Abhängigkeit davon, ob der betreffend Kurzschluß bereits vorliegt, wenn der Microcontroller 21 die SLEEP- oder STANDBY-Zustandsinstruktion an den IC 100 überträgt, oder ob der Kurzschluß erst auftritt nachdem zuvor der SLEEP- oder STANDBY-Betriebszustand ordnungsgemäß erreicht worden ist.

Die festverdrahtete Logik des IC 100 bewirkt, daß der die kurzschlußfehlerhafte Busader überwachende Pegeldiskriminator oder Komparator innerhalb des Funktionsblocks 132 verriegelt wird und als unmittelbare Folge dieses Schaltvorganges der (lokale) Abschluß an eben diese Busader auf "Kurzschluß erkannt" umgeschaltet wird, d.h. die Stromquelle 26 oder 27 bzw. der Widerstand 26' oder 27' wirksam geschaltet wird.

Sobald der Kurzschluß verschwindet, zieht der entsprechende, sehr geringe Eingangsstrom (in Fig. 3a z.B. an 8 (RTH) oder 12 (CAN_L) im SLEEP-oder STANDBY-Betriebszustand die betreffende Bus-Ader auf ein Potential nahe dem in diesen Betriebsarten normalen Potential. Als Folge wird der Bus-Abschluß auf den im SLEEP- und STANDBY-Betriebszustandnormalen umgeschaltet (16 und 17' wirksam).

Zur Übersicht sind in **Fig. 11** alle von dem IC 100 insgesamt erkennbaren Einfach-Fehlerzustände im Busnetz zusammengestellt, wobei die geklammerten Ziffern die einzelnen Busfehler gemäß nachfolgender Liste repäsentieren:
(1) Unterbrechung von CAN_L
(2) Unterbrechung von CAN_H
(3) Versorgungsschluß an CAN_L
(4) Masseschluß von CAN_H
(5) Masseschluß von CAN_L
(6) Versorgungsschluß an CAN_H
(7) Kurzschluß zwischen CAN_H und CAN_L

Beim Busfehler
(8) Paarige Unterbrechung von CAN_H und CAN_L handelt es sich in Strenge um einen Doppelfehler, der deshalb **unmittelbar** eindeutig nur von dem IC 100 im Gerät n erkannt werden kann (z.B. zwecks Failsafe-Auslösung der von diesem Gerät normalerweise zu steuernden Funktion).

Wesentlich ist, daß die im IC 100 festverdrahtete Busfehler-Response-Logik (Logik mit definierten Fehler-Antworten) in jedem einzelnen Busteilnehmer - mit der busweiten Wirkung einer verteilten Fehlerbehandlungsintelligenz im Netz - die Realisierung von Fehler-Responsezeiten in der Größenordnung von einer (Bus-)Bitzeit **und darunter** ermöglicht, so daß Botschaftsverluste im Zuge einer busfehlerbedingten Umkonfiguration der Sende- und Empfangskomponenten von 100 weitgehend oder vollständig vermieden werden können. Dies ist ein großer Vorzug gegenüber allen auf Softwarebasis zentral ausgerichteten Busmasterlösungen.

In den IC 100 mitimplementiert sein kann ferner die schon erwähnte Versorgungsüberwachung, deren Zweck und Funktion speziell unter Zugrundelegung eines Umfeldes gemäß Fig. 1a sich wie folgt erklären.

Durch die Abschaltbarkeit des Spannungsreglers 20 im SLEEP-Zustand wird der Microcontroller 21 regelmäßig stromlos. Deshalb muß eine Initialisierung aus dem stromlosen Zustand vorgesehen werden, sobald der Regler über seinen PWROR-Ausgang 20.4 den Microcontroller 21 zurückgesetzt hat.

Im Falle des Beispiels eines Kraftfahrzeugs muß der Microcontroller in die Lage versetzt werden, bei jeder neuen Inbetriebnahme auf inkrementale Daten, die zumindest während des letzten Betriebs des Kraftfahrzeugs Gültigkeit hatten und Einstellzuständen entsprechen, wie sie der Benutzer vor der erneuten Inbetriebnahme vorfindet, zurückzugreifen, also beispielsweise auf Daten, welche die Einstellung von verstellbaren Sitzen, Rückspiegeln, etc. betreffen.

Dies wird typischerweise durch Abspeicherung der Daten in einem EEPROM des Microcontrollers 21 und deren Ladung ins RAM des letzteren beim Beginn einer jeden Inbetriebnahme geleistet. Auf diese Weise werden Anschlagsläufe zur Feststellung der aktuellen Einstellposition in Bezug auf die Endanschläge verstellbarer Elemente und der hierfür unumgängliche und lästige Zeitverbrauch überflüssig.

Im Falle, daß das den Microcontroller 21 enthaltende Gerät aus einem Bussystem entfernt wird, um es z.B. zu ersetzen oder in ein anderes Busnetz einzusetzen, tritt in diesem Zusammenhang das Problem auf, daß der Microcontroller allein für sich genommen eine solche Handhabung des ihn enthaltenden Geräts als (eigentliche) Ursache für eine zuvor eingetretene Stromlosigkeit nicht erfassen kann.

Aus diesem Grund würde er - nach der Einrüstung des betreffenden Gerätes in ein neues Bus-Netz - auch im neuen Bus-Netz die zuvor eingelernten und in seinem EEPROM aufbewahrten Daten weiterhin als gültige betrachten und verwenden, was bei der Inbetriebnahme im neuen Bus-Netz zu Fehlsteuerungen der von dem betrachteten Gerät zu steuernden Elemente führte.

Dieser Problematik abzuhelfen ist Aufgabe der in den IC 100 zweckmäßigerweise mitintegrierten Versorgungsüberwachung und insbesondere des aus der Diskrimination der Spannungspegel VBATT und VCC im Funktionsblock 110 abgeleitete POWERFAIL-Kriteriums, welches über den Pfad 152 in den Steuerungs block 140 gelangt. Dabei wird ausgenutzt, daß der IC 100 seine elektrische Versorgung aus dem dem Regler 20 vorgelagerten, höheren Potential VBATT bezieht, welches bei Unterbrechung der Versorgung aus dem übergeordneten Potential UBATT - bei einem Fahrzeug beispielsweise durch Unterbrechung der Stromzufuhr von Klemme 30 - schneller zusammenbricht als das durch Sieb- und Stützkapazitäten 161 wie aus Fig. 13 ersichtlich für gewisse Mindestzeitspannen zu haltende Potential VCC.

Zu diesem Zweck werden im Funktionsblock 110 Spannungspegelüberwachungen beispielhaft gemäß nachfolgendem Schema vorgenommen und ausgewertet; dabei sind ohne Beschränkung der Allgemeinheit beispielhaft wieder die Situation in einem Kraftfahrzeug und dabei beispielhaft auftretende Spannungen zugrundegelegt:

Ist z.B. VBATT > 6V und VCC = 5V, darf weder der Microcontroller 21 noch der IC 100 einen Powerfail-Zustand erkennen.

Der Funktionsblock 110 diskriminiert jedenfalls VBATT mit normalerweise 12 Volt gegen einen Grenzwert VL1 von beispielsweise 3,5 Volt. Für den Fall, daß der Microcontroller 21 bzw. dessen Watchdog keine eigene Powerfail-Erkennung aufweist, diskriminiert er des weiteren VCC mit normalerweise 5V gegen einen zweiten Grenzwert VL2 von beispielsweise 1V (Grenzspannung für dynamische Datenhalbarkeit im RAM des Microcontrollers 21).

Im Rahmen der Vorrichtung soll unerheblich sein, ob der Microcontroller über eine eigene Powerfail-Erkennung für VCC verfügt. Denkbar ist auch, daß beispielsweise eine hier nicht näher beschriebene, separate Watchdog-Funktion für den Microcontroller eine entsprechende VCC-Diskriminierung und -Auswertung leistet, soweit die von der Einrichtung vorteilhaft mitumfaßte nicht oder anders genutzt wird.

Im Rahmen der Vorrichtung kann unabhängig davon, ob der Microcontroller 21 sich noch auf eigene Hilfsschaltungen wie z.B. eine watchdogarmierte Versorgungsspannungsüberwachung stützt, an 4 ein POWERFAIL-INTERRUPT-Signal ausgegeben werden, das entweder nur auf eine Diskrimination von VBATT oder auf eine kombinierte Diskrimination von VBATT und VCC zurückgeht. Wenn nachfolgend also von einem Powerfail-Flag des IC 100 die Rede ist, bedeutet dies nicht, daß der Microcontroller 21 keine eigene VCC-Überwachung hat oder über keine Hilfsschaltkreise hierfür verfügt.

Beispielsweise anläßlich eines Motorstarts wird bei VBATT > VL1 und VCC > VL2 weder für VBATT noch für VCC auf Powerfail erkannt, und folglich an 4 auch kein entsprechendes Signal ausgegeben. Der Microcontroller 21 erkennt folglich bei seinem Neustart nach Reset am Fehlen (Nichtgesetztsein) des Powerfail-Flags im Funktionsblock 145 bzw. 143 bezüglich VCC und/oder VBATT, daß weder ein Neueinlernen noch ein Update von inkrementalen Daten aus dem eigenen EEPROM erforderlich ist, arbeitet also mit den aktuell in seinem RAM befindlichen weiter. Das Powerfail-Flag wird hierbei beispielsweise gemäß **Fig. 12a** im Zeitraum zwischen t₈ und t₉ gelesen und dann, wenn es vor dem Übergang des vom Microcontroller 21 ausgegebenen Signals EN von "L" nach "H" gesetzt ist, in ein INTERRUPT-Signal an 4 ausgewertet, welches vom Microcontroller 21 als wahr erkannt und als POWERFAIL-INTERRUPT interpretiert wird.

Bei einem erschwerten Motorstart im Winter kann die Bordnetzspannung UBATT jedoch von der anfänglichen Nennspannung für kurze Zeit sehr weit, nämlich unter VL1 abfallen, mit der Folge, daß auch VBATT entsprechend weit abfällt, während VCC nach initialer Bestromung des Reglers 20 vermöge einer letzterem nachgeordneten Stützkapazität 161 noch oberhalb VL2 gehalten wird. Im Block 110 wird deshalb zwar der Versorgungszustand VBATT < VL1 erkannt, zugleich aber der Versorgungszustand VCC > VL2, was im Funktionsblock 145 bzw. 143 das Setzen des Powerfail-Flags verhindert (Inhibit).

Aus dem Nichtgesetztsein des Powerfail-Flags folgt die Nichtausgabe eines INTERRUPT-Signals an 4 (aus Powerfail für VBATT). Der Microcontroller 21 erkennt aus dem Fehlen dieses Interrupts, daß weder ein Neueinlernen noch ein Update inkrementeller Daten aus dem eigenen EEPROM erforderlich ist und arbeitet mit den in seinem RAM aktuell befindlichen Daten weiter.

Hingegen kann im Falle eines normal abgelaufenen Motorstarts, jedoch (z.B. kurzzeitigen) Zusammenbruchs des Speisepotentials VCC aus welchen Gründen auch immer die Situation VBATT > VL1, VCC < VL2 auftreten. Diesbezüglich ist eine Auswertung wie folgt möglich. Logische Mittel im Funktionsblock 145 bzw. 143 bewirken, daß in diesem Falle ein Setzen des Powerfail-Flags in 143 und somit die Ausgabe eines INTERRUPTs an 4 unterbleibt.

Verfügt der Microcontroller 21 über eine eigene VCC-Überwachung oder eine solche ihm besorgende Hilfsmittel, d.h. über ein eigenes Powerfail-Flag, kann er am Fehlen des externen POWERFAIL-INTERRUPTs an 4 von 100 und dem Gesetztsein seines eigenen VCC-Powerfail-Flags erkennen, daß ein Neueinlernen von inkrementellen Daten nicht erforderlich ist, jedoch die Daten, die aktuell gelten sollen, zuerst aus seinem EEPROM in sein RAM geladen werden müssen.

Der letzte Fall des vollständigen Zusammenbruchs des Bordnetzes beispielsweise anläßlich langanhaltender Startversuche - mit der Wirkung, daß auch VCC zusammenbricht - wird gleich behandelt wie der Ausbau der Batterie oder eine Unterbrechung der Stromversorgung von Klemme 30 zum betrachteten Busteilnehmer, d.h. wie die Entfernung eines entsprechenden Gerätes aus seinem Bus-Netz.

In einem solchen Falle wird VBATT < VL1 = 3,5 Volt und VCC < VL2 = 1 Volt. Diese beiden Bedingungen haben ein Setzen des Powerfail-Flags im Funktionsblock 145 bzw. 143 zur Folge und folglich die Ausgabe eines POWERFAIL-INTERRUPT-Signals an 4 von 100. Außerdem wird im Microcontroller auch dessen Powerfail-Flag bezüglich VCC gesetzt. Diesen Zustand und das POWERFAIL-INTERRUPT-Signal an 4 wertet der Microcontroller 21 als Erfolgtsein einer Abtrennung und eines Wiederanschlusses an die dauerstromversorgte Klemme 30 aus. Dies bewirkt, daß er beim Neustart Endanschläge und relative Lage(n) des von ihm gesteuerten Elements einlernt und in sein EEPROM abspeichert.

Da speziell im SLEEP-Zustand VCC = 0 Volt und in bzw. aus diesem Zustand immer ein Powerfail bezüglich VCC vom Microcontroller erkannt werden kann, kommt es bezüglich der Auswertung, ob das den Microcontroller 21 und den IC (100) enthaltende elektronische Gerät im SLEEP-Zustand von seiner Stromversorgung getrennt wurde, im wesentlichen auf die Powerfail-Erkennung bezüglich VBATT im Funktionsblock 145 bzw. 143 an, die in der beschriebenen Weise seitens der Einrichtung geleistet wird.

Durch geeignete Bemessung von Stützkapazitäten für VCC bzw. daraus abgeleitete Versorgungspotentiale digitaler Schaltkreisfunktionen in Verbindung mit dem Microcontroller 21 kann z.B. die Forderung erfüllt werden, daß eine z.B. 1,5 Sekunden dauernde Unterbrechung des Versorgungspotentials UBATT ohne Datenverlust und Powerfail-Erkennung bezüglich VCC möglich ist, daß hingegen nach einer Unterbrechungsdauer von beispielsweise wenigstens 30 Sekunden beim Neustart des Microcontrollers ein Neulernzyklus bezüglich der auf Endanschläge inkremental abzuspeichernden Daten ausgelöst wird.

Der Rahmen der Vorrichtung ist im Hinblick auf die möglichen Funktionen der Blöcke 110 und 143 nicht auf die vorgenannten beispielhaften Versorgungsüberwachungen beschränkt. Insoweit können auch andere, die sich von den obigen unterscheiden, je nach Anwendungsfall zweckmäßig sein. Insbesondere kann der IC dann, wenn er eine größere Zahl von Anschlüssen aufweisen kann (auch bei Integration als Standardzelle) noch zusätzliche Eingänge zur Selektion verschiedener fest programmierter Versorgungsüberwachungsarten aufweisen, die gemäß Selektionsbeschaltung bzw. -ansteuerung auswählbar sind.

In Zusammenhang mit einer solchen Versorgungsüberwachung kann optional die bereits erwähnte Zwangsfreischaltung der Sendeendstufe 133 vorgesehen sein mit der Wirkung, daß die Endstufe 133 von CAN-H/CAN_L abgetrennt wird, wenn das Potential VBATT und/oder VCC unter einen vorbestimmten Schwellwert abfällt, wodurch eine die Funktion des Busses beeinträchtigende Bürde vermieden wird. Diesen Aspekt versinnbildlicht die Verbindung 157 in **Fig. 2.**

Die Vorrichtung umfaßt auch noch die Überwachung irgend einer Spannung, die je nach Applikation für die Funktion des IC 100 oder seines Umfeldes, in das er einzubinden ist, im Block 110 noch integriert sein. Ein Beispiel für eine solche Spannung könnte z.B. eine Kontrollspannung aus aus einem Schaltregler für Steuergeräte mit höherer Betriebsspannung UBATT, etwa in Nutzfahrzeugen, sein. Dabei ist nicht nur an die Auswertung des Unterschreitens unterer, sondern auch oberer Grenzwerte oder des Verlassens von Spannungsfenstern gedacht. Die Auswertung zu einem ERR/INT-Signal an 4 kann auch hierbei im Funktionsblock 145 erfolgen.

Wie sich beispielsweise ein Steuergerät mit dem gegenständlichen IC in der Konfiguration gemäß **Fig. 1a** bezüglich wesentlicher Spannungs- und Signalpegel nach der Beaufschlagung mit dem Versorgungs-/Speisepotential UBATT/VBATT und der kooperierende Microcontroller bezüglich des hier beispielhaft betriebsartabhängig zu interpretierenden ERR/INT-Signals verhält, ist in **Fig. 12a** zeitdiagrammatisch und in **Fig. 12b** auch anhand eines Funktionschaltbildes dargestellt.

Demgemäß erfolgt zur Zeit t₃ die Anschaltung der Einrichtung an UBATT bzw. VBATT. Nach kurzer Verzögerung gibt der IC 100 im Zeitpunkt t₄ am Steuerausgang 1 das Signal ENA/NINH an den Steuereingang 20.3 des Reglers 20 ab. Daraufhin baut sich bis zum Zeitpunkt t₅ die Speisespannung VCC des Microcontrollers 21 auf. Im nachfolgenden Zeitpunkt t₆ gibt der Regler 20 das PWROR-Signal zwecks Rücksetzung des Microcontrollers 21 zur Initialisierung ab.

Um diese Reaktion sicherzustellen, kann der IC 100 - und insbesondere sein Funktionsblock 110 - noch besondere Mittel umfassen, welche bewirken, daß bei Inbetriebnahmebeaufschlagung des Einganges 14 mit VBATT (Anschalten eines Steuergerätes mit dem IC und Spannungsregler an UBATT) das ENA/NINH-Signal initial zunächst erzeugt wird unabhängig vom logischen Status der EN- und STB-Eingänge, so daß eine Bestromung des Microcontrollers 21 zur Einlesung seiner anschließend den Betriebszustand des IC 100 steuernden EN- und STB-Signale überhaupt möglich ist (Latchup to Go).

Die anschließend Interpretation eines an 4 auftretenden ERR/INT-Signales durch den Microcontroller 21 geschieht in Abhängigkeit vom logischen Pegel der von ihm ausgegebenen STB- und EN-Signale, und - da diese die Betriebsart des IC vorgeben - in Abhängigkeit von dessen Betriebsarten SLEEP, STANDBY/RECEIVE ONLY und NORMAL, wie folgt.

Bis zur Zeitspanne t₇ hat der Microntroller 21 seine Initialisierung samt Port-Check sicher abgeschlossen.

Während einer daran anschließenden, zwischen t₇ und t₈ definierten Zeitspanne, der sog. POWER-ON PHASE, haben beide Signale STB und EN seitens des Microcontrollers noch den logischen Pegel "L", entsprechend einer Einstellung des IC 100 auf die Betriebsart SLEEP. Wird in diesem logischen Zustand ein Wake UP-Signal z.B. vom Schalter 25 an 7 erkannt, wird im Funktionsblock 145 bzw. 143 das Wake Up-Flag gesetzt. Dies führt im Zustand, bevor das STB-Signal von "L" auf "H" übergeht, zur Auslösung eines INTERRUPT-Signals an 4, d.h. im ersten Signalfenster für ERR/INT. Ein INTERRUPT an 4 in dieser Zeitspanne wird vom Microcontroller 21 als WAKEUP INTERRUPT interpretiert. Diesem Fall entspricht in **Fig. 12b** die obere Schalterstellung zum Abfragen des Wake Up-Flipflops im Block 145 bzw. 143.

In wenigstens einem Teil der POWER-ON PHASE kann vorzugsweise die Busfehlererkennung 132 durch Mittel, die beispielsweise durch die Anstiegsflanke VCC am Anschluß 10 des IC 100 wirksam sind, noch inaktiv sein.

Während der daran zwischen t₈ und t₉ sich anschließenden Zeitspanne, der sog. RECEIVE ONLY PHASE, gibt der Microcontroller STB = "H", EN = "L" aus. Wurde zuvor bzw. wird das Powerfail-Flag in 145 bzw. 143 gesetzt, führt dies jedenfalls in diesem logischen Zustand bevor das EN-Signal von "L" auf "H" übergeht zur Auslösung eines INTERRUPT-Signals an 4, d.h. im zweiten Signalfenster für ERR/INT. Ein INTERRUPT an 4 in dieser Zeitspanne wird vom Microcontroller 21 als POWERFAIL INTERRUPT interpretiert. Diesem Fall entspricht in **Fig. 12b** die mittlere Schalterstellung zum Abfragen des Powerfail-Flip-flops im Block 145 bzw. 143.

Sobald der Zeitpunkt t₉ erreicht ist, ist volle Kommunikationsfähigkeit hergestellt und der Microcontroller gibt EN = "H", STB = "H" aus. Wurde zuvor bzw. wird das Bus Error-Flag im Busfehlerauswertungsblock 144 bzw. in 143 gesetzt, führt dies in diesem logischen Zustand zur Auslösung eines INTERRUPT-Signals an 4, d.h. im dritten Signalfenster für ERR/INT. Ein INTERRUPT an 4 ab dem Zeitpunkt t₉ wird vom Microcontroller 21 als BUS ERROR-INTERRUPT interpretiert. Diesem Fall entspricht in **Fig. 12b** die untere Schalterstellung zum Abfragen des Bus Error-Flipflops im Block 144 bzw. 143.

In **Fig. 12b** ist auch das Zurücksetzen des Wake Up-Flags und des Powerfail-Flags veranschaulicht. Es geschieht in Abhängigkeit von den Signalen EN und STB dann, wenn sowohl EN = "H" und STB = "H". Damit ist sichergestellt, daß nach einem folgenden Übergang in die Betriebsart SLEEP (EN = "L", STB = "L") beim erneuten Wecken das Flag-Register wieder jungfräulich und somit setzbar ist.

Ein elektronisches Steuergerät, welches den erfindungsgemäßen IC umfaßt, kann insoweit grob ein Gesamtblockschaltbild gemäß **Fig. 13** aufweisen. Außer bereits bekannten Teilen ist hier noch eine zentrale Stützkapazität 161 für das Potential VCC am Reglerausgang 20.2, ein die Taktfrequenz des Microcontrollers 21 bestimmendes Bauteil 162 und als Schnittstelle zwischen Sensoren sowie Aktuatoren und dem Microcontroller 21 mit Busprotokoll-Modul 22 ein Input/Output-Interface 163 angedeutet, das sowohl aus VCC als auch aus VBATT stromversorgt wird. Diese Darstellung macht ersichtlich, daß auch der IC 100 sowohl hinsichtlich seiner oben beschriebenen Funktionen als auch seiner Anordnung im Kommunikationspfad gewissermaßen als Interface zwischen CAN_H/CAN-L und Microcontroller 21 bzw. dem Busprotokoll-Modul verstanden werden kann.

Auch im Hinblick darauf erweist sich als wichtig, daß der IC 100 und insbesondere seine Sendeendstufe 133 inhärent gegen alle möglichen Busfehler geschützt ausgeführt sein können und im Rahmen des Funktionsblockes 130 vermöge der Funktionsblöcke 131 und 132 die Busbehandlung im Fehlerfalle zur Aufrechterhaltung einer Kommunikationsfunktionalität rein hardwaremäßig unter Ausschluß des Microcontrollers geschieht. Dadurch wird der Microcontroller und die ihm zugeordnete Busprotokoll-Funktion vollkommen abschaltbar.

Dieses Merkmal wird noch gestützt durch eine optional mögliche Ausbildung der Sendemittel 130 bzw. wenigstens der davon umfaßten Endstufe 133 dahingehend, daß sie sich bei Vorliegen eines Defekts in dem sie umfassenden IC 100 selbsttätig vom Bus freischaltet/en, wodurch eine Blockierung des Bus-Netzes durch ein insoweit gestörtes Gerät vermieden wird.

Zur Vollständigkeit sei erwähnt, daß die Mittel des IC 100, vermöge derer im Fehlerfalle die Erkennung der besten noch bestehenden Möglichkeit einer Notkommunikation über den Bus und die Einstellung und/oder Umkonfiguration und/oder Adaption der Sende- und Empfangsmittel geschieht, auf der Basis analoger Vergleiche der Busaderpotentiale mit fixen Toleranzfenstern für diese Potentiale wirken können.

Wird der IC in einer robusten Technologie hergestellt, welche insbesondere Überspannungen im Applikationsfeld zu widerstehen vermag und auch verträglich mit dort zu erwartenden elektromagnetischen Störeinstrahlungen ist (z.B. keine Bezugspegelverschiebung durch HF-Gleichrichteffekte in/bei Komparatoren in 121 und 132 etc.), bildet er zugleich - in der Art eines Schutzwalles vor dem Microcontroller - ein physikalisches Sicherungsinterface für hochsensible Schaltelemente wie z.B. A/D-Wandler und digitale Schaltkreise eines Steuergerätes.

Bei einer solchen Realisierungsweise kann der IC auch besondere, mitintegrierte Mittel umfassen, welche an sich erforderliche externe Schutzmittel ersetzen, um die am Bus liegenden Empfangs- und Sendemittel nach außen widerstandsfähig gegenüber allen in der Praxis busweit möglichen Kurzschluß- und Fehlerzuständen zu machen.

Ohne Beschränkung der Allgemeinheit kann der IC 100 gemäß **Fig. 2** dieshinsichtlich u.a. auch Filterelemente 80 und 81 - insbesondere mit Tiefpaßcharakteristik - mitumfassen. Beispielsweise kann ein solches Filterelement 80 zwischen Anschluß 7 und dem Funktionsblock 111 (WAKEUP-Logic) angeordnet sein. Entsprechende Filterelemente 81 können im Verlaufe des gemeinsamen Busanschlußpfades CAN_H/CAN_L der Funktionsblöcke 111 und 132 angeordnet sein. Andere Filterelemente 82 können im Verlaufe des Busanschlußpfades von den Anschlüssen 11 und 12 zum Empfänger-Frontend 121 angeordnet sein.

Solche Filterelemente erhöhen den Störabstand und verringern die Ansprechempfindlichkeit des IC 100 auf hochfrequente Einstreuungen sowie auf hochfrequente Störsignale, die sich bei busfehlerbedingtem Eindrahtbetrieb über Mas-se GND im Pfad des Masserückschlusses zum Nutz(not-) signal hinzuaddieren. Im einfachsten Falle kann es sich hierbei um analoge RC-Tiefpässe handeln, deren Elemente in der IC 100 auch schaltungstopologisch verteilt sein können. Gleichwohl kann es sich dabei um quasi-digitale Filter handeln, beispielsweise um solche mit vorbestimmter Ansprechzeit in der Größenordnung mehrerer Busbitlängen.

Andererseits können solche Filterelemente 80, 81 und 82 unterschiedlich realisiert sein und unterschiedliche Charakteristika aufweisen, um beispielsweise unterschiedlichen Störungsmöglichkeiten in den Betriebsarten SLEEP und NORMAL mit und ohne Fehler bzw. der schnellen Busfehler-Erkennung und -Behandlung binnen kürzester Zeit Rechnung zu tragen.

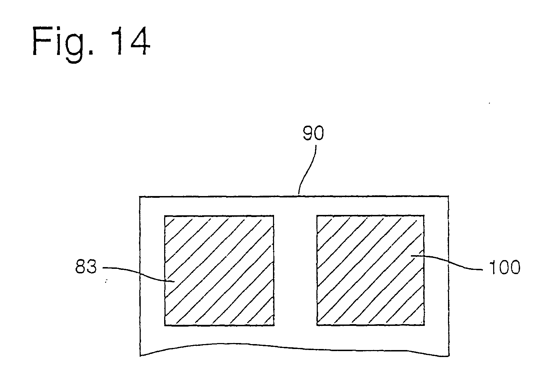

Der Rahmen der Erfindung umspannt weiter, daß der IC 100 gemäß **Fig. 14** zusammen mit einer anderen beliebigen Schaltkreisfunktion 83 auf einem einzigen Halbleiter-Substrat 90 realisiert und insoweit beide jeweils monolithisch ausgeführt sind.

## Patentansprüche

1. Integrierter Halbleiterschaltkreis (100) für ein elektronisches Steuergerät mit Microcontroller (21), wobei das Steuergerät mit Mitteln zur Kommunikation mit anderen kommunikationsfähigen Steuergeräten mit Microcontrollern ausgestattet ist, um mit letzteren ein Netzwerk (CAN) zu bilden, in welchem die Bus-Kommunikation protokollbasiert seriell geschieht und wofür der Bus als Zweidrahtleitung ausgebildet und jedes Steuergerät mit einem Busprotokoll-Modul (22) mit Empfangseingang (Rx) und Sendeausgang (Tx) ausgestattet ist, und wobei der Halbleiterschaltkreis (100) umfaßt:
- Empfangsmittel (120) mit zwei Eingängen zum Anschluß an die beiden Busadern (CAN_H, CAN_L) und einem Ausgang (3) zum Anschluß an den Empfangseingang (Rx) des Busprotokoll-Moduls (22) und
- Sendemittel (133) mit einem Eingang (2) zum Anschluß an den Sendeausgang (Tx) des Busprotokoll-Moduls (22) und zwei Ausgängen (11, 12) zum Anschluß an die beiden Busadern (CAN_H, CAN_L);
- Busfehler-Erkennungsmittel (132), die ein Auftreten eines die normale Kommunikationsweise über beide Busadern beeinträchtigenden Busfehlers erkennen;
- Busfehler-Auswertungsmittel (144) zur Aufbereitung wenigstens eines an den Microcontroller (21) abgebbaren (4, 24) Fehler- bzw. Unterbrechungssignals (ERR/INT);
**dadurch gekennzeichnet, daß**
- Abschlußelemente (16 an CAN_H, 17 an CAN_L) zwischen den beiden Busadern und Masse bzw. Versorgungsspannung (Vcc, Ubat) vorgesehen sind, die mit zwei Eingängen (8, 9) des Halbleiterschaltkreises (100) verbunden sind,
- **daß** mit den Busfehler-Erkennungsmitteln (132) kooperative Bus-Abschluß-Umschaltmittel (131) vorgesehen sind, die jedes Abschlußelement (16, 17) im Fehlerfall und/oder abhängig von der Betriebsart an die zugeordnete Busader (CAN_H, CAN_L) umoder hochohmig schalten.

2. Integrierter Halbleiterschaltkreis (100) für ein elektronisches Steuergerät mit Microcontroller (21), wobei das Steuergerät mit Mitteln zur Kommunikation mit anderen kommunikationsfähigen Steuergeräten mit Microcontrollern ausgestattet ist, um mit letzteren ein Netzwerk (CAN) zu bilden, in welchem die Bus-Kommunikation protokollbasiert seriell geschieht und wofür der Bus als Zweidrahtleitung ausgebildet und jedes Steuergerät mit einem Busprotokoll-Modul (22) mit Empfangseingang (Rx) und Sendeausgang (Tx) ausgestattet ist, wobei der Halbleiterschaltkreis (100) umfaßt:
- Empfangsmittel (120) mit zwei Eingängen zum Anschluß an die beiden Busadern (CAN_H, CAN_L) und einem Ausgang (3) zum Anschluß an den Empfangseingang (Rx) des Busprotokoll-Moduls (22) und
- Sendemittel (133) mit einem Eingang (2) zum Anschluß an den Sendeausgang (Tx) des Busprotokoll-Moduls (22) und zwei Ausgängen (11, 12) zum Anschluß an die beiden Busadern (CAN_H, CAN_L);
**dadurch gekennzeichnet, daß**
- der Halbleiterschaltkreis (100) zwischen die Busadern (CAN_H, CAN_L) und das dem Microcontroller (21) zugeordnete Busprotokoll-Modul (22) geschaltet ist,
- der Halbleiterschaltkreis (100) wenigstens in den zwei verschiedenen Betriebsarten "Senden und Empfang / NORMAL" sowie "Schlafen / SLEEP" mit abgeschaltenem Spannungsregler betreibbar ist, und **daß**
- er ferner einen Eingangsport (5, 6) zum Empfang wenigstens eines Selektionssignales (EN, STB) des Microcontrollers (21) zur Auswahl einer dieser wenigstens zwei Betriebsarten aufweist; und
- **daß** er ferner wenigstens einen Eingang (7) zum Empfang eines Wecksignals sowie mit den beiden Busadern (CAN_H, CAN_L) in Verbindung stehende Weck-/Fehlspannungs-Erkennungsmittel (111) und des weiteren Schaltmittel (141) zur Bereitstellung eines Schaltsignals (ENA/NINH) sowie Weck-/Fehlspannungs-Auswertungsmittel (145) zur Aufbereitung und Abgabe (4, 24) eines Ergebnissignals aufweist, wenn in der Betriebsart "SLEEP" ein Wecksignal vom Bus (CAN_H, CAN_L) oder vom Eingang (7) erkannt wird.

3. Integrierter Halbleiterschaltkreis nach Anspruch 1 oder 2,
**dadurch gekennzeichnet, daß** im integrierten Halbleiterschaltkreis ein Fehlersignalisierungs-Modul (143) vorhanden ist, das als Resultat einer logischen Verknüpfung eines Ergebnissignales eines Busfehler-Auswertungsmittels (144) mit einem Ergebnissignal eines Weck-/Fehlspannungsauswertungsmittels (145) ein resultierendes Fehler- bzw. Unterbrechungssignal (ERR/INT, 4 bei 143) generiert und an den Microcontroller (21) abgibt.

4. Integrierter Halbleiterschaltkreis nach Anspruch 1,
**dadurch gekennzeichnet, daß**
- die Bus-Abschluß-Umschaltmittel (131) so beschaffen sind, **daß** sie abhängig von der Art eines erkannten Busfehlers anstelle wenigstens eines der Abschlußelemente (16, 17) erste und zweite, im Halbleiterschaltkreis fest integrierte Ersatzabschlußelemente (26, 27; 26', 27') an wenigstens eine der beiden Busadern (CAN_H, CAN_L) schalten (S₁, S₂, S₃, S_{OH}).

5. Integrierter Halbleiterschaltkreis nach Anspruch 1,
**dadurch gekennzeichnet, daß**
- er Bus-Abschluß-Umschaltmittel (131) umfaßt die insgesamt so beschaffen sind, **daß** sie in der Betriebsart "SLEEP" einen impedanzmäßig asymmetrischen Abschluß der beiden Busadern (CAN_H, CAN_L) gegenüber der Bezugsmasse (GND) des Halbleiterschaltkreises bewirken.

6. Integrierter Halbleiterschaltkreis nach Anspruch 5,
**dadurch gekennzeichnet, daß**
- seine Bus-Abschluß-Umschaltmittel (131) so beschaffen sind, **daß** sie in der Betriebsart "NORMAL" zwei identische Abschlußelemente (16, 17) an die beiden Busadern schalten (S₁, S₂), und
- **daß** sie in der Betriebsart "SLEEP" anstelle wenigstens eines dieser Elemente (17) wenigstens ein im Halbleiterschaltkreis fest integriertes Ersatzabschlußelement (17') an die betreffende Busader (CAN_L) schalten (S₃).

7. Integrierter Halbleiterschaltkreis nach Anspruch 6,
**dadurch gekennzeichnet, daß**
- es sich bei dem ersten Ersatzabschluß (17') um einen Widerstand handelt, welcher einen Wert aufweist, der größenordnungsmäßig ein Vielfaches des Wertes des Widerstandes des Abschlußelements (17) beträgt.

8. Integrierter Halbleiterschaltkreis nach Anspruch 6,
**dadurch gekennzeichnet, daß**
- er Busfehler-Erkennungsmittel (132) umfaßt, welche wenigstens einen spezifischen, in der Betriebsart "SLEEP' aus wirksamen Busfehler erkennen um die Bus-Abschluß-Umschaltmittel (131) zu veranlassen, das fest integrierte Ersatzabschlußelement (17') unwirksam zu schalten oder vom Bus (CAN_L) abzutrennen und statt dessen wenigstens ein zweites Ersatzabschlußelement (27, 27') an den Bus (CAN_L) zu schalten.

9. Integrierter Halbleiterschaltkreis nach einem der Ansprüche 1 und 8,
**dadurch gekennzeichnet, daß**
- das zweite Ersatzabschlußelement (27) durch eine eingeprägte Stromquelle realisiert ist.

10. Integrierter Halbleiterschaltkreis nach einem der Ansprüche 1 und 8,
**dadurch gekennzeichnet, daß**
- das zweite Ersatzabschlußelement (27') ein hochohmigen Widerstand ist.

11. Integrierter Halbleiterschaltkreis nach Anspruch 8,
**dadurch gekennzeichnet, daß**
- das zweite Ersatzabschlußelement (27, 27') so in Bezug auf das fest integrierte Ersatzabschlußelement (17') dimensioniert ist, **daß** durch das zweite Ersatzabschlußelement (27, 27') im Fehlerfall ein geringerer Strom fließt als durch das fest integrierte Ersatzabschlußelement ohne Vorliegen eines Fehlers.

12. Integrierter Halbleiterschaltkreis nach Anspruch 1,
**dadurch gekennzeichnet, daß**
- er ferner wenigstens einer der Betriebsarten
- Nur-Empfang (RECEIVE ONLY)
- Bereitschaft (STANDBY)
fähig ist, in welchen entweder die Stromversorgung der Sendemittel (133) abschaltbar ist oder die Sendemittel (133) vom Bus (CAN_H/CAN_L) freischaltbar sind.

13. Integrierter Halbleiterschaltkreis nach Anspruch 12,
**dadurch gekennzeichnet, daß**
- die Freischaltung durch Blockierung eines Steuereinganges (EN) zur aktiven Anschaltung der Sendemittel an den Bus (CAN_H/CAN_L) geschieht.

14. Integrierter Halbleiterschaltkreis nach einem der Ansprüche 1 oder 2,
**dadurch gekennzeichnet, daß**
- er Mittel (110) zur Überwachung einer Spannung wenigstens auf Unterschreitung oder Überschreitung eines Grenzwertes umfaßt, sowie
- Auswertungsmittel (145) zur Aufbereitung wenigstens eines an den Microcontroller (21) abgebbaren (4; 24) Fehler- bzw. Unterbrechungssignals (ERR/INT), wenn die Unterschreitung oder Überschreitung erfolgt.

15. Integrierter Halbleiterschaltkreis nach einem der Ansprüche 1 oder 2,
**dadurch gekennzeichnet, daß**
- er Mittel (110) zur Überwachung der Betriebsspannung (VCC) des Microcontrollers (21) auf Unterschreitung eines Grenzwertes (VL2) umfaßt, sowie
- Auswertungsmittel (145) zur Aufbereitung wenigstens eines an den Microcontroller (21) abgebbaren (4; 24) Fehler- bzw. Unterbrechungssignals (ERR/INT), wenn diese Betriebsspannung (VCC) unter besagten Grenzwert abfällt.

16. Integrierter Halbleiterschaltkreis nach Anspruch 1,
**dadurch gekennzeichnet, daß**
- die Busfehler-Auswertungsmittel (144) und die Mittel (145) zur Auswertung des Unterschreitens des Grenzwertes (VL2) ausgangsseitig verknüpft sind zwecks Abgabe eines an den Microcontroller (21) abgebbaren (4; 24) Fehler- bzw. Unterbrechungssignals (ERR/INT).

17. Integrierter Halbleiterschaltkreis nach Anspruch 1,
**dadurch gekennzeichnet, daß**
- er Filterelemente (81, 82) umfaßt und diese so geschaltet sind, **daß** je eines davon wenigstens zwischen jeweils der einen Busader (CAN_H, CAN_L) und dem entsprechenden der beiden Eingänge der Empfangsmittel (120) und/oder der Busfehler-Erkennungsmittel wirksam ist.

18. Integrierter Halbleiterschaltkreis nach Anspruch 1,
**dadurch gekennzeichnet, daß**
- er Filterelemente (81, 82) umfaßt und diese so geschaltet sind, **daß** je eines davon wenigstens zwischen jeweils der einen Busader (CAN_H, CAN_L) und dem entsprechenden der beiden Eingänge der Empfangsmittel (120) und/oder der Weck-Erkennungsmittel (111) wirksam ist.

19. Integrierter Halbleiterschaltkreis nach Anspruch 1,
**dadurch gekennzeichnet, daß**
- er wenigstens ein Filterelement (80) umfaßt, das zwischen dem Eingang für ein Wecksignal (7) und den Weck-Erkennungsmitteln (111) wirksam ist.

## Claims

1. Integrated semiconductor circuit (100) for an electronic control device with micro-controller (21), the control device being provided with means for communicating with other control devices with microcontrollers having communication capability in order to form a network (CAN) with the latter in which bus communication is effected serially on a protocol basis, for which purpose the bus is provided as a two-wire line and each control device is provided with a bus protocol module (22) with receiver input (Rx) and transmitter output (Tx), the semiconductor circuit (100) comprising:
- receiver means (120) with two inputs for connecting to the two bus wires (CAN_H, CAN_L) and an output (3) for connecting to the receiver input (Rx) of the bus protocol module (22) and
- transmitter means (133) with an input (2) for connecting to the transmitter output (Tx) of the bus protocol module (22) and two outputs (11, 12) for connecting to the two bus wires (CAN_H, CAN_L);
- bus error detection means (132) which detect the occurrence of any bus error which might impair the normal communication mode via both bus wires;
- bus error evaluation means (144) for preparing at least one error and interrupt signal (ERR/INT) which can be transmitted (4, 24) to the micro-controller (21);
**characterised in that**
- terminal elements (16 on CAN_H, 17 on CAN_L) are provided between the two bus wires and ground or supply voltage (Vcc, Ubat) and are connected to two inputs (8, 9) of the semiconductor circuit (100),
- co-operating with the bus error detection means (132) are bus terminal-switching means (131) which switch each terminal element (16, 17) to the co-operating bus wire (CAN_H, CAN_L) or high resistance in the event of an error and/or depending on the operating mode.

2. Integrated semiconductor circuit (100) for an electronic control device with micro-controller (21), the control device being provided with means for communicating with other control devices with microcontrollers having communication capability in order to form a network (CAN) with the latter in which bus communication is effected serially on a protocol basis, for which purpose the bus is provided as a two-wire line and each control device is provided with a bus protocol module (22) with receiver input (Rx) and transmitter output (Tx), the semiconductor circuit (100) comprising:
- receiver means (120) with two inputs to connect to the two bus wires (CAN_H, CAN_L) and an output (3) for connecting to the receiver input (Rx) of the bus protocol module (22) and
- transmitter means (133) with an input (2) for connecting to the transmitter output (Tx) of the bus protocol module (22) and two outputs (11, 12) for connecting to the two bus wires (CAN_H, CAN_L);
**characterised in that**
- the semiconductor circuit (100) is connected between the bus wires (CAN_H, CAN_L) and the bus protocol module (22) co-operating with the micro-controller (21),
- the second conductor circuit (100) can be operated in at least two operating modes, "send and receive/NORMAL" as well as "stand-by/SLEEP" with the voltage regulator switched off, and **in that**
- it additionally has an input port (5, 6) for receiving at least one selection signal (EN, STB) of the micro-controller (21) for selecting one of these at least two operating modes; and **in that**
- it additionally has at least one input (7) for receiving a wake-up signal as well as wake-up/no-voltage detection means (111) connected to the two bus wires (CAN_H, CAN_L) and other switching means (141) for supplying a switching signal (ENA/NINH) as well as wake-up/no-voltage evaluation means (145) for preparing and transmitting (4, 24) a result signal if a wake-up signal is detected by the bus (CAN_H, CAN_L) or by the input (7) whilst in "SLEEP" mode.

3. Integrated semiconductor circuit as claimed in claim 1 or 2,
**characterised in that**
an error signalling module (143) is provided in the integrated semiconductor circuit which, as a result of a logical link between a result signal of a bus error evaluation means (144) and a result signal of a wake-up/no-voltage evaluation means (145), generates a resultant error and interrupt signal (ERR/INT, 4 at 143) and transmits it to the micro-controller (21).

4. Integrated semiconductor circuit as claimed in claim 1,
**characterised in that**
- the bus terminal switching means (131) are configured so that, depending on the nature of the detected bus error, they switch (S₁, S₂, S₃, S_{OH}), instead of at least one of the terminal elements (16, 17), first and second substitute terminal elements (26, 27; 26', 27'), permanently integrated in the semiconductor circuit, to at least one of the two bus wires (CAN_H, CAN_L).

5. Integrated semiconductor circuit as claimed in claim 1,
**characterised in that**
- it has bus terminal switching means (131) which are configured overall so that, in "SLEEP" mode, they cause a termination of the two bus wires (CAN_H, CAN_L) with asymmetrical impedance relative to the ground (GND) of the semiconductor circuit.

6. Integrated semiconductor circuit as claimed in claim 5,
**characterised in that**
- its bus terminal switching means (131) are configured so that, in "NORMAL" mode, they switch (S₁, S₂) two identical terminal elements (16, 17) to the two bus wires and
- in "SLEEP" mode, instead of at least one of these elements (17), they switch (S₃) at least one substitute terminal element (17'), permanently integrated in the semiconductor circuit, to the relevant bus wire (CAN_L).

7. Integrated semiconductor circuit as claimed in claim 6,
**characterised in that**
- the first substitute terminal (17') is a resistor, the value of which is a multiple of the value of the resistor of the terminal element (17).

8. Integrated semiconductor circuit as claimed in claim 6,
**characterised in that**
- it has bus error detection means (132), which detect at least one specific bus error of several that are active in "SLEEP" mode in order to prompt the bus terminal switching means (131) to switch the permanently integrated substitute terminal element (17') to inactive mode or isolate it from the bus (CAN_L) and instead switch at least a second substitute terminal element (27, 27') to the bus (CAN_L).

9. Integrated semiconductor circuit as claimed in one of claims 1 and 8,
**characterised in that**
- the second substitute terminal element (27) is an applied current source.

10. Integrated semiconductor circuit as claimed in one of claims 1 and 8,
**characterised in that**
- the second substitute terminal element (27') is a high-resistance resistor.

11. Integrated semiconductor circuit as claimed in claim 8,
**characterised in that**
- the second substitute terminal element (27, 27') is so dimensioned relative to the permanently integrated substitute element (17') **that** a weaker current flows through the second substitute terminal element (27, 27') in the event of an error than through the permanently integrated substitute terminal element when no error is present.

12. Integrated semiconductor circuit as claimed in claim 1,
**characterised in that**
- it is additionally capable of operating in at least one of the operating modes
- RECEIVE ONLY
- STANDBY,
in which either the current supply of the transmitter means (133) can be switched off or the transmitter means (133) can disconnected from the bus (CAN_H/CAN_L).

13. Integrated semiconductor circuit as claimed in claim 12,
**characterised in that**
- the disconnection is effected by blocking a control input (EN) actively connecting the transmitter means to the bus (CAN_H/CAN_L).

14. Integrated semiconductor circuit as claimed in one of claims 1 or 2,
**characterised in that**
- it has means (110) for monitoring a voltage, at least to ascertain whether it rises above or falls below a threshold value, and
- evaluation means (145) for preparing at least one error and interrupt signal (ERR/INT) which can be transmitted (4; 24) to the micro-controller (21) if it does rise above or fall below.

15. Integrated semiconductor circuit as claimed in one of claims 1 or 2,
**characterised in that**
- it has means (110) for monitoring whether the operating voltage (VCC) of the micro-controller (21) falls below a threshold value (VL2), and
- evaluation means (145) for preparing at least one error and interrupt signal (ERR/INT) which can be transmitted (4; 24) to the micro-controller (21) if this operating voltage (VCC) does fall below said threshold value.

16. Integrated semiconductor circuit as claimed in claim 1,
**characterised in that**
- the bus error evaluation means (144) and the means (145) for evaluating a fall below the threshold value (VL2) are linked on the output side in order to supply an error and interrupt signal (ERR/INT) which can be transmitted (4; 24) to the micro-controller (21).

17. Integrated semiconductor circuit as claimed in claim 1,
**characterised in that**
- it has filter elements (81, 82) and the latter are connected so that one of them respectively is active at least between the one bus wire (CAN_H, CAN_L) and the corresponding one of the two inputs of the receiver means (120) and/or the bus error detection means.

18. Integrated semiconductor circuit as claimed in claim 1,
**characterised in that**
- it has filter elements (81, 82) and the latter are connected so one of them respectively is active at least between the one bus wire (CAN_H, CAN_L) and the corresponding one of the two inputs of the receiver means (120) and/or the wake-up detection means (111).

19. Integrated semiconductor circuit as claimed in claim 1,
**characterised in that**
- it has at least one filter element (80), which is active between the input for a wake-up signal (7) and the wake-up detection means (111).

## Revendications

1. Circuit intégré à semi-conducteur (100) destiné à un appareil de commande électronique doté d'un microcontrôleur (21), l'appareil de commande étant pourvu de moyens pour communiquer avec d'autres appareils de commande capables de communiquer et de microcontrôleurs, afin de former avec ces derniers un réseau (CAN) au sein duquel la communication du bus intervient en série sur la base de protocoles et pour lequel le bus est conçu sous la forme d'une ligne à deux fils et chaque appareil de commande est pourvu d'un module de protocole du bus (22) présentant une entrée réceptrice (Rx) et une sortie émettrice (Tx), et le circuit intégré à semi-conducteur (100) comprenant :
- des moyens de réception (120) dotés de deux entrées pour le raccordement aux deux conducteurs du bus (CAN_H, CAN_L) et une sortie (3) pour le raccordement à l'entrée réceptrice (Rx) du module de protocole du bus (22), et,
- des moyens d'émission (133) dotés d'une entrée (2) pour le raccordement à la sortie émettrice (Tx) du module de protocole du bus (22) et de deux sorties (11, 12) pour le raccordement aux deux conducteurs du bus (CAN_H, CAN_L),
- des moyens d'identification d'erreurs du bus (132), qui reconnaissent la survenance d'une erreur du bus préjudiciable à la bonne exécution de la communication via les deux conducteurs du bus,
- des moyens d'analyse d'erreurs du bus (144) pour la régénération d'au moins un signal d'interruption ou d'erreur (ERR/INT) susceptible d'être émis (4, 24) au niveau du microcontrôleur (21),
**caractérisé en ce que**
sont prévus des éléments de fermeture, (16 au niveau de CAN_H), (17 au niveau de CAN_L), entre les deux conducteurs du bus et la masse ou la tension d'alimentation (Vcc, Ubat) qui sont reliés à deux entrées (8, 9) du circuit à semi-conducteur (100),
- des moyens coopératifs d'inversion de fermeture du bus (131) sont prévus avec les moyens d'identification d'erreurs du bus (132) qui inversent ou commutent à haute impédance, au niveau du conducteur du bus associé, (CAN_H, CAN_L) chaque élément de fermeture (16, 17) en cas d'erreurs et/ou en fonction du mode de fonctionnement.

2. Circuit intégré à semi-conducteur (100) destiné à un appareil de commande électronique doté d'un microcontrôleur (21), l'appareil de commande étant pourvu de moyens pour communiquer avec d'autres appareils de commande capables de communiquer et de microcontrôleurs, afin de former avec ces derniers un réseau (CAN) au sein duquel la communication du bus intervient en série sur la base de protocoles et pour lequel le bus est conçu sous la forme d'une ligne à deux fils et chaque appareil de commande est pourvu d'un module de protocole du bus (22) présentant une entrée réceptrice (Rx) et une sortie émettrice (Tx), et le circuit intégré à semi-conducteur (100) comprenant :
- des moyens de réception (120) dotés de deux entrées pour le raccordement aux deux conducteurs du bus (CAN_H, CAN_L) et une sortie (3) pour le raccordement à l'entrée réceptrice (Rx) du module de protocole du bus (22) et,
- des moyens d'émission (133) dotés d'une entrée (2) pour le raccordement à la sortie émettrice (Tx) du module de protocole du bus (22) et de deux sorties (11, 12), pour le raccordement aux deux conducteurs du bus (CAN_H, CAN_L),
**caractérisé en ce que**
- le circuit à semi-conducteur (100) est monté entre les conducteurs du bus (CAN_H, CAN_L) et le module de protocole du bus (22) affecté au microcontrôleur (21),
- le circuit à semi-conducteur (100) est capable de fonctionner au moins dans les deux modes différents "Emission et réception/NORMAL " et "Veille/SLEEP" avec un régulateur de tension déconnecté,
- il présente, en outre, un port d'entrée (5, 6), destiné à la réception d'au moins un signal de sélection (EN/STB) du microcontrôleur (21) pour sélectionner au moins un de ces deux modes de fonctionnement, et,
- il possède en outre au moins une entrée (7) pour la réception d'un signal de réveil, ainsi que des moyens d'identification de la tension d'erreurs/de réveil (111) reliés aux deux conducteurs du bus (CAN_H, CAN_L) et du moyen de commutation supplémentaire (141) pour la mise à disposition d'un signal de commutation (ENA/NINH) ainsi que des moyens d'analyse de la tension d'erreurs/de réveil (145) pour la régénération et l'émission (4, 24) d'un signal de résultat, en cas d'identification d'un signal de réveil du bus (CAN_H, CAN_L) ou de l'entrée (7) en mode de fonctionnement "SLEEP".

3. Circuit intégré à semi-conducteur selon la revendication 1 ou 2, **caractérisé en ce qu'**il existe, dans le circuit intégré à semi-conducteur s, un module de signalisation d'erreurs qui génère un signal d'interruption ou d'erreurs (ERR/INT), (4 pour 143), consécutif, en tant que résultat d'une liaison logique d'un signal de résultat d'un moyen d'analyse d'erreurs du bus (144) avec un signal de résultat d'un moyen d'analyse de la tension d'erreurs/de réveil (145) et qui émet au niveau du microcontrôleur (21).

4. Circuit intégré à semi-conducteur selon la revendication 1, **caractérisé en ce que** les moyens d'inversion de fermeture du bus (131) sont proposés de manière à ce qu'indépendamment de la nature d'une erreur du bus identifiée, ils commutent à la place d'au moins un des éléments de fermeture (16, 17), le premier et le second éléments de fermeture de remplacement (26, 27, 26', 27'), solidement intégrés dans le circuit à semi-conducteur et ce, au niveau d'au moins un des deux conducteurs du bus (CAN_H, CAN_L) (S₁, S₂, S₃, S_{OH}).

5. Circuit intégré à semi-conducteur selon la revendication 1, **caractérisé en ce qu'**il comprend des moyens d'inversion de fermeture du bus (131), tous conçus de telle sorte qu'en mode de fonctionnement "SLEEP", ils génèrent une fermeture conforme à l'impédance et asymétrique des deux conducteurs du bus (CAN_H, CAN_L,) par rapport à la masse de référence (GND) du circuit à semi-conducteur.

6. Circuit intégré à semi-conducteur selon la revendication 5, **caractérisé en ce que**
- ses moyens d'inversion de fermeture du bus (131) sont conçus de sorte qu'en mode de fonctionnement "NORMAL", ils commutent deux éléments de fermeture identiques (16, 17) au niveau des deux conducteurs du bus (S₁, S₂) et,
- ils commutent, en mode de fonctionnement "SLEEP", à la place d'au moins un de ces éléments (17), au moins un élément de fermeture de remplacement (17'), solidement intégré dans le circuit à semi-conducteur s, et ce, au niveau du conducteur du bus (CAN_L) concerné (S_{3.)}

7. Circuit intégré à semi-conducteur selon la revendication 6, **caractérisé en ce qu'**il s'agit, **en ce** **qui** concerne la première fermeture de remplacement (17'), d'une résistance présentant une valeur qui est, toute proportion gardée, un multiple de la valeur de la résistance de l'élément de fermeture (17).

8. Circuit intégré à semi-conducteur selon la revendication 6, **caractérisé en ce qu'**il comprend des moyens d'identification d'erreurs du bus (132) qui reconnaissent, en mode de fonctionnement "SLEEP", à partir d'erreurs effectives du bus, au moins une erreur spécifique, afin d'inviter les moyens d'inversion de fermeture du bus (131) à ne pas commuter l'élément de fermeture de remplacement solidement intégré (17') ou de l'isoler du bus (CAN_L) et à la place, de commuter au moins un des deux éléments de fermeture de remplacement (27, 27') au niveau du bus (CAN_L).

9. Circuit intégré à semi-conducteur selon l'une des revendications 1 et 8, **caractérisé en ce qu'**une source de courant appliquée réalise le second élément de fermeture de remplacement (27).

10. Circuit intégré à semi-conducteur selon l'une des revendications 1 et 8, **caractérisé en ce que** le second élément de fermeture de remplacement (27') est une résistance à valeurs ohmiques élevées.

11. Circuit intégré à semi-conducteur selon la revendication 8, **caractérisé en ce que** le second élément de fermeture de remplacement (27, 27') est dimensionné en référence à l'élément de fermeture de remplacement solidement intégré (17') de telle sorte qu'en cas d'erreur, un courant plus faible que celui traversant le premier élément de fermeture de remplacement solidement intégré, traverse le second élément de fermeture de remplacement (27, 27') sans qu'une erreur ne survienne.

12. Circuit intégré à semi-conducteur selon la revendication 1, **caractérisé en ce qu'**il est en outre capable de fonctionner au moins dans l'un des modes suivants :
- en réception uniquement (RECEIVE ONLY),
- en veille (STANDBY),
au niveau desquels soit l'alimentation en courant des moyens d'émission (133) peut être coupée, soit les moyens d'émission (133) peuvent être mis hors tension du bus (CAN_H/CAN_L).

13. Circuit intégré à semi-conducteur selon la revendication 12, **caractérisé en ce que** le blocage d'une entrée de commande (EN) pour la connexion active des moyens d'émission au niveau du bus (CAN_H/CAN_L) génère la mise hors tension.

14. Circuit intégré à semi-conducteur selon l'une des revendications 1 ou 2, **caractérisé en ce qu'**il possède :
- des moyens (110) destinés à surveiller une tension, et ce, au moins en ce qui concerne le sous-dépassement ou le dépassement d'une valeur de seuil, ainsi que,
- des moyens d'analyse (145) pour la régénération d'au moins un signal d'interruption ou d'erreur (ERR/INT) susceptible d'être émis (4, 24) au niveau du microcontrôleur (21), en cas de sous-dépassement ou de dépassement.

15. Circuit intégré à semi-conducteur selon l'une des revendications 1 ou 2, **caractérisé en ce qu'**il possède :
- des moyens (110) destinés à surveiller la tension de fonctionnement (VCC) du microcontrôleur (21) et ce, en ce qui concerne le sous-dépassement d'une valeur de seuil (VL2), ainsi que,
- des moyens d'analyse (145) pour la régénération au moins d'un signal d'interruption ou d'erreur (ERR/INT) susceptible d'être émis (4, 24) au niveau du microcontrôleur (21), si cette tension de fonctionnement (VCC) tombe en dessous de la valeur de seuil mentionnée.

16. Circuit intégré à semi-conducteur selon la revendication 1, **caractérisé en ce que** les moyens d'analyse d'erreurs du bus (144) et les moyens (145) destinés à analyser le sous-dépassement de la valeur de seuil (VL2) sont connectés côté sortie en vue de l'émission d'un signal d'interruption ou d'erreur (ERR/INT) susceptible d'être émis (4, 24) au niveau du microcontrôleur (21).

17. Circuit intégré à semi-conducteur selon la revendication 1, **caractérisé en ce qu'**il possède des éléments filtrants (81, 82) et **en ce que** ceux-ci sont commutés de telle sorte que l'un d'entre eux soit effectif entre au moins l'un des conducteurs du bus (CAN_H, CAN_L) et le conducteur correspondant des deux entrées des moyens de réception (120) et/ou des moyens d'identification d'erreur de bus.

18. Circuit intégré à semi-conducteur selon la revendication 1, **caractérisé en ce qu'**il possède des éléments filtrants (81, 82) et que ceux-ci sont commutés de telle sorte que l'un d'entre eux soit effectif entre au moins l'un des conducteurs du bus (CAN_H, CAN_L) et le conducteur correspondant des deux entrées des moyens de réception (120) et/ou des moyens d'identification de réveil (111).

19. Circuit intégré à semi-conducteur selon la revendication 1, **caractérisé en ce qu'**il possède au moins un élément filtrant (80) effectif entre l'entrée destinée à un signal de réveil (7) et les moyens d'identification de réveil (111).
